# EUROPEAN PATENT APPLICATION

(11) **EP 4 789 864 A1**
(43) Date of publication of application: **12.08.2026**
(21) Application number: 25204297.3
(22) Date of filing: 24.09.2025
(51) Int. Cl.: B32B 7/06, B32B 7/12, G02F 1/1333, H10K 59/10

(54) **FILM FOR DISPLAY DEVICE, METHOD OF MANUFACTURING FILM FOR DISPLAY DEVICE, AND ELECTRONIC DEVICE**

(30) Priority: 07.02.2025 KR 20250015725
(71) Applicant: Samsung Display Co., Ltd., Yongin-si, Gyeonggi-do 17113 (KR)
(72) Inventor: Jung, Tai Yun, 17113 Yongin-si, Gyeonggi-do (KR); Baek, Seung Hwan, 17113 Yongin-si, Gyeonggi-do (KR); Jo, Jae Hyun, 17113 Yongin-si, Gyeonggi-do (KR); Kim, Min Ki, 17113 Yongin-si, Gyeonggi-do (KR)
(74) Representative: Gulde & Partner

(57) **Abstract**

A film (DF) for a display device (DD) includes a release layer (LL) including a protection portion (PP) and a pull-tab portion (PT) protruding from one side (L1, L2) of the protection portion (PP), an adhesive layer (PSL) arranged on the release layer (LL), and a thin-film (DF) layer (TF) arranged on the adhesive layer (PSL), where end portions of the protection portion (PP), the adhesive layer (PSL), and the thin-film (DF) layer (TF) overlap each other in a plan view, and the protection portion (PP) and the pull-tab portion (PT) are arranged in a same layer as each other.

## Description

### BACKGROUND

### 1. Field

Embodiments of the disclosure generally relate a film for a display device, a method of manufacturing a film for the display device, and an electronic device including the display device.

### 2. Description of Related Art

With the development of information technology, the importance of a display device, which is a connection medium between a user and information, is being highlighted. Accordingly, research and development of display devices are continuously being carried out.

One configuration or element of the display device may be formed by peeling off a release layer from a film for the display device including the release layer, and then attaching the film for the display device to another configuration or element of the display device.

When the release layer is peeled off from the film for the display device, one configuration of the display device may not be appropriately formed unless the release layer is appropriately peeled off from the film for the display device.

### SUMMARY

Embodiments of the present disclosure provide a film for a display device and a method of manufacturing the film for the display device, from which a release layer may be properly peeled off.

Embodiments of the present disclosure provide a film for a display device and a method of manufacturing the film for the display device that may improve process efficiency.

Embodiments of the present disclosure provide an electronic device including a display device with reduced manufacturing cost and improved reliability.

In accordance with an embodiment of the disclosure, a film for a display device includes a release layer including a protection portion and a pull-tab portion protruding from one side of the protection portion, an adhesive layer arranged on the release layer, and a thin-film layer arranged on the adhesive layer, wherein end portions of the protection portion, the adhesive layer, and the thin-film layer overlap each other in a plan view, and the protection portion and the pull-tab portion are arranged in a same layer as each other.

As used herein, the expression "overlap each other in a plan view" may mean that, when viewed in a top-down projection (the plan view), respective regions of the protection portion, the adhesive layer, and the thin-film layer are disposed such that they at least partially occupy a common plan-view area such that the regions at least partially overlap. In some embodiments, the overlap is complete, i.e., the regions are coextensive in plan view and exactly coincide in position, thereby forming a complete mutual overlap in the plan view.

Furthermore, the expression "in a same layer as each other" may mean that the protection portion and the pull-tab portion are disposed in a common plane, i.e. they are arranged co-planar with one another, without any vertical offset.

In an embodiment, the film may include an attachment portion and a protrusion portion protruding from one side of the attachment portion, wherein the pull-tab portion may correspond to the protrusion portion or may be disposed at the protrusion portion and wherein the protection portion, the adhesive layer and the thin-film layer may correspond to the attachment portion or may be disposed at the attachment portion.

In an embodiment, the film for the display may include a support layer arranged under the pull-tab portion and contacting the release layer. The support layer may also be partially arranged under the protection portion.

In an embodiment, when viewed in a plan view, at least one region of an edge of the support layer may coincide with an edge of the pull-tab portion. In an embodiment, for example, when viewed in a plan view, at least one region of a side surface of the support layer may overlap a side surface of the pull-tab portion. In an embodiment, for example, when viewed in a plan view, at least one region of the side surface of the support layer may form a same plane (or a same planar surface) with the side surface of the pull-tab portion.

In an embodiment, side surfaces of the protection portion, the adhesive layer, and the thin-film layer may be on a same plane. In other words, respective lateral faces of the protection portion, the adhesive layer, and the thin-film layer may be arranged such that they extend in alignment with one another, thereby defining a common planar surface. This embodiment may include arrangements in which the side surfaces are flush and co-planar so that no step, offset, or protrusion is present between the adjacent side surfaces. According to another embodiment, the alignment may be complete, i.e. the side surfaces are entirely co-planar and define a continuous common planar surface across their full extent.

In an embodiment, the thin-film layer may include a central area arranged at a center of the thin-film layer, side areas extending from edges of the central area, and corner areas connecting the side areas to each other, a length of a side where one of the corner areas and a corresponding one of the side areas meet each other may be greater than zero (0) millimeter (mm) and less than or equal to about 30 mm, and the one side of the protection portion from which the pull-tab portion protrudes may overlap a corresponding one of the corner areas in the plan view. In other words, the thin-film layer may include a central area arranged at a center portion of the thin-film layer, a plurality of side areas extending outwardly from edges of the central area, and corner areas connecting adjacent side areas to each other. A length of a side at which one of the corner areas and a corresponding one of the side areas meet may be greater than zero (0) mm and less than or equal to about 30 mm. In other words, from respective edges of this central area, a plurality of side areas may extend outwardly. Corner areas may be provided at the intersections of adjacent side areas, such that the corner areas mechanically and geometrically connect the side areas to one another, thereby forming a continuous outline of the thin-film layer. A length of a side defined at the boundary where one of the corner areas meets a corresponding side area may be greater than zero (0) mm and less than or equal to about 30 mm. The central area, the side areas, and the corner areas may overlap the attachment portion when viewed in a plan view. The one side of the protection portion from which the pull-tap portion protrudes may coincide with an edge of the corresponding one of the corner areas in a plan view.

In an embodiment, the pull-tab portion may include a first pull-tab portion connected to and extending from the protection portion, a second pull-tab portion connected to and extending from the first pull-tab portion, and a third pull-tab portion connected to and extending from the second pull-tab portion, where the second pull-tab portion has a width increasing as a distance from the first pull-tab portion increases in the plan view, and each of the first pull-tab portion and the third pull-tab portion has a constant width in the plan view. In a plan view, the first pull-tab portion may have a substantially rectangular shape with a constant width, thereby defining a uniform interface to the protection portion. The second pull-tab portion may extend from the first pull-tab portion and may exhibit a flaring geometry, such that its width increases gradually as the distance from the first pull-tab portion increases. This widening may be linear, forming a trapezoidal shape, or curvilinear, forming a funnel-like outline. The third pull-tab portion may extend from a wider end of the second pull-tab portion and again may have a constant width, thereby forming a uniform extension that continues beyond the flared region. The constant width of the third pull-tab portion may correspond to the maximum width of the second portion, thereby creating a step-free transition, or may be smaller to provide a narrowed extension.

In an embodiment, the first pull-tab portion may have a smaller width than the third pull-tab portion in the plan view, and/or a width of the first pull-tab portion may be in a range of about 1 mm to about 40 mm in the plan view. The width of the first pull-tab portion may be in a range of about 10 mm to about 30 mm in the plan view.

In an embodiment, the pull-tab portion may have a rectangular shape in the plan view.

In an embodiment, the pull-tab portion may include a first pull-tab portion connected to and extending from the protection portion, a second pull-tab portion connected to and extending from the first pull-tab portion, and a third pull-tab portion connected to and extending from the second pull-tab portion, the second pull-tab portion may have a width decreasing as a distance from the first pull-tab portion increases in the plan view, and each of the first pull-tab portion and the third pull-tab portion may have a constant width in the plan view. In a plan view, the first pull-tab portion may have a substantially rectangular shape with a constant width, thereby defining a uniform interface to the protection portion. The second pull-tab portion may extend from the first portion and may exhibit a narrowing geometry, such that its width decreases gradually as the distance from the first portion increases. This reduction in width may be linear, forming a trapezoidal narrowing, or curvilinear, forming a tapering funnel-like outline. The third pull-tab portion may extend from a narrow end of the second pull-tab portion and again may have a constant width, thereby forming a uniform extension that continues beyond the narrowed region. The constant width of the third pull-tab portion may correspond to the minimum width of the second portion, thereby creating a step-free transition, or may be smaller to provide a narrowed extension.

In an embodiment, the release layer may include a first surface on which the adhesive layer is arranged, the first surface may include irregularities in which a part of the first surface protrudes, and/or a groove defined by a recessed region of the first surface, and the groove may be adjacent to a boundary region between the protection portion and the pull-tab portion. In other words, the first surface may include irregularities in which a part of the first surface protrudes relative to surrounding regions. Such protrusions may be formed as elevations, ribs, or localized raised portions, which can serve, for example, to improve mechanical engagement, increase surface roughness for adhesion, or guide the positioning of adjoining elements. The irregularities may be, e. g. only, arranged in areas in which the adhesive layer is arranged on the first surface. In other words, the irregularities may contact the adhesive layer. In addition, or alternatively, a groove may be defined by a recessed region of the first surface. The groove may extend linearly, curved, or in a patterned manner, and may have a uniform or varying depth. In some embodiments, the groove may be disposed adjacent to a boundary region between the protection portion and the pull-tab portion. As used herein, the term "boundary region" may refer to an interface area between the protection portion and the pull-tab portion. The boundary region may include an exact line or surface of contact as well as a finite surrounding zone extending into each of the adjoining elements.

In an embodiment, the thin-film layer may include copper (Cu), and/or the thin-film layer may have a thickness greater than zero (0) micrometer (µm) and less than or equal to about 50 µm. The thin-film layer may have a thickness greater than 10 µm and less than or equal to about 40 µm.

In an embodiment, the thin-film layer may include a step forming portion having a shape in which at least a part of an edge thereof is indented toward the central area when viewed in a plan view. The step forming portion may be formed in plural according to an embodiment. At least one of the plurality of step forming portions may be arranged to overlap one of the corner areas when viewed in a plan view. The step forming portion may be immediately adjacent to the pull-tab portion or may be spaced apart from the pull-tab portion when viewed in a plan view.

In accordance with an embodiment of the disclosure, a method of manufacturing a film for a display device includes forming a base adhesive layer on a first surface of a base release layer, forming a base thin-film layer on the base adhesive layer, forming a base support layer on a second surface of the base release layer, removing (e. g. along a first cutting line) a first portion of the base thin-film layer and a first portion of the base adhesive layer, and removing (e. g. along a second cutting line) a second portion of the base thin-film layer, a second portion of the base adhesive layer, a portion of the base release layer, and a portion of the base support layer, where in the removing the first portion of the base thin-film layer and the first portion of the base adhesive layer, a portion (in other words, a exposed portion) of the first surface is exposed, and in the removing the second portion of the base thin-film layer, the second portion of the base adhesive layer, the portion of the base release layer, and the portion of the base support layer, a release layer including a protection portion and a pull-tab portion protruding from one side of the protection portion is formed by removing the portion of the base release layer.

In an embodiment, the method may include forming a film laminate, wherein the forming the film laminate may include forming the base adhesive layer on the first surface of the base release layer, forming the base thin-film layer on the base adhesive layer, and forming the base support layer on the second surface of the base release layer.

In an embodiment, a portion of the first surface resulting from the removing the first portion of the base thin-film layer and the first portion of the base adhesive layer may have a rectangular shape in the plan view.

In an embodiment, the portion of the first surface resulting from the removing the first portion of the base thin-film layer and the first portion of the base adhesive layer may be formed by removing a corner region of the respective elements. For example, a corner portion may be cut away such that the resulting exposed portion defines a substantially rectangular surface in plan view. In this case, the corresponding cut side surface may likewise be formed as a rectangular surface region. By removing a corner region in the removing the first portion of the base thin-film layer and the first portion of the base adhesive layer, remaining portions of the base thin-film layer and of the base adhesive layer may together form a step shape at the respective corner. In other words, the cutting away of one corner portion results in a geometry in which the surfaces of the base thin-film layer and of the base adhesive layer are arranged with an offset, so that the adjoining region exhibits a step-like contour.

In an embodiment, the base support layer may be arranged to overlap a region in which the pull-tab portion is to be formed when viewed in a plan view.

In an embodiment, the base support layer may cover a portion of the second surface of the base release layer and expose a remaining portion of the second surface of the base release layer.

The second surface may be opposite to the first surface.

In an embodiment, in the removing the first portion of the base thin-film layer and the first portion of the base adhesive layer, a side surface of the first portion of the base thin-film layer and a side surface of the first portion of the base adhesive layer may be cut to form a same planar surface, and a remaining portion (in other words, a covered portion) other than the portion (the exposed portion) of the first surface is covered by the base adhesive layer. In other words, material may be removed from each of the respective side surfaces so that, when combined, the side surfaces lie flush in a common plane without step or offset. Furthermore, a remaining portion other than the portion (the exposed portion) of the first surface, may be covered by the base adhesive layer. Accordingly, the removed portion of the respective side surface, or the cut respective side surface itself, may likewise be formed as a substantially rectangular surface region in plan view. In other words, starting from a stacked structure comprising the base support layer, the base release layer, the base adhesive layer and the base thin-film layer in said order, a portion of the base thin-film layer and the base adhesive layer may be removed. In the plan view (plane spanned by a first direction and second direction), a region of the base support layer and the base release layer may remain exposed beneath the removed portions of the base thin-film layer and the base adhesive layer. This exposed region can subsequently be processed by further removal to form the pull-tab portion.

In an embodiment, in the removing the first portion of the base thin-film layer and the first portion of the base adhesive layer, the respective portions of the base thin-film layer and the base adhesive layer may be cut. The first portion of the base thin-film layer and the first portion of the base adhesive layer may be cut in a same process.

In an embodiment, in the removing the second portion of the base thin-film layer, the second portion of the base adhesive layer, the portion of the base release layer, and the portion of the base support layer, the second portion of the base thin-film layer may be cut to form a thin-film layer, the second portion of the base adhesive layer may be cut to form an adhesive layer, the portion of the base release layer may be cut to form the release layer, and the portion of the base support layer may be cut to form the support layer, the second portion of the base thin-film layer, the second portion of the base adhesive layer, the portion of the base release layer, and the portion of the support layer may be cut in a same process, and end portions of the thin-film layer, the adhesive layer, and the protection portion of the release layer may overlap each other in the plan view. In other words, remaining portions of the base thin-film layer, the base adhesive layer, the base release layer and the base support layer may respectively form the thin-film layer, the adhesive layer, the release layer (e. g. so that the release layer may include the protection portion and the pull-tap portion), and the support layer of the film according to an embodiment after cut portions are removed. In other words, when viewed from above, end or terminal regions of the respective elements occupy a common area, at least partially covering one another. In some embodiments, the overlap of the end portions may be partial, i.e. only certain sections of the respective end portions coincide. In other embodiments, the overlap may be complete, such that the end portions are coextensive in plan view and exactly coincide in position.

In an embodiment, the thin-film layer may include a central area arranged in a center of the thin-film layer, side areas extending from edges of the central area, and corner areas connecting the side areas to each other, a length of a side where one of the corner areas and a corresponding one of the side areas meet each other may be greater than zero (0) mm and less than or equal to about 30 mm, and the one side of the protection portion from which the pull-tab portion protrudes may overlap a corresponding one of the corner areas in the plan view.

In an embodiment, the pull-tab portion may include a first pull-tab portion connected to and extending from the protection portion, a second pull-tab portion connected to and extending from the first pull-tab portion, and a third pull-tab portion connected to and extending from the second pull-tab portion, the second pull-tab portion may have a width increasing as a distance from the first pull-tab portion increases in the plan view, where the first pull-tab portion has a constant width in a range of 1 mm to 40 mm in the plan view, and the third pull-tab portion may have a greater width than the first pull-tab portion and a constant width in the plan view.

In an embodiment, the pull-tab portion may have a rectangular shape in the plan view.

In an embodiment, the pull-tab portion may include a first pull-tab portion connected to and extending from the protection portion, a second pull-tab portion connected to and extending from the first pull-tab portion, and a third pull-tab portion connected to and extending from the second pull-tab portion, where the second pull-tab portion has a width decreasing as a distance from the first pull-tab portion increases in the plan view, and each of the first pull-tab portion and the third pull-tab portion has a constant width in the plan view.

In an embodiment, in the removing the first portion of the base thin-film layer and the first portion of the base adhesive layer, a groove may be formed in a region of the first surface when the first portion of the base thin-film layer and the first portion of the base adhesive layer are cut. The groove may be formed by cutting or removing one region of the first surface, e. g. by cutting at least a part of the first surface of the base release layer together with the first portion of the base thin-film layer and the first portion of the base adhesive layer, so that the groove in which a part of the first surface is recessed may be formed.

In an embodiment, for example, in the removing the first portion of the base thin-film layer and the first portion of the base adhesive layer, the base release layer may not be cut completely through in a thickness direction (e.g., a third direction).

In accordance with an embodiment of the disclosure, an electronic device includes a display device and a processor, where the display device includes a display panel, and a film attached to a rear surface of the display panel, where the film includes a thin-film layer, and an adhesive layer attached between the thin-film layer and the display panel, and edges of the thin-film layer includes first portions having end portions coinciding with the display panel in a plan view, and second portions arranged between the first portions and connecting the first portions to each other, where the second portions defines a step in the plan view.

In an embodiment, the electronic device may include the film according to an embodiment of the disclosure.

In an embodiment, the thin-film layer may include a central area arranged in a center of the thin-film layer, side areas extending from edges of the central area, and corner areas connecting the side areas to each other, where a length of a side where one of the corner areas and a corresponding one of the side areas meet each other may greater than zero (0) mm and less than or equal to about 30 mm or less, and in the plan view, at least one of the second portions may overlap a corresponding one of the corner areas.

### BRIEF DESCRIPTION OF THE DRAWINGS

The above and other features of embodiments of the disclosure will become more apparent by describing in further detail embodiments thereof with reference to the accompanying drawings, in which:
FIG. 1 is a schematic cross-sectional view of a film for a display device according to an embodiment;
FIG. 2 is a schematic perspective view of a film for a display device according to an embodiment;
FIGS. 3 to 6 are schematic plan views of a film for a display device according to an embodiment;
FIG. 7 is a flowchart illustrating a method of manufacturing a film for a display device according to an embodiment;
FIG. 8 is a schematic perspective view showing the film laminate;
FIG. 9 is a schematic perspective view showing a first cutting line in a film laminate;
FIG. 10 is a schematic perspective view showing a second cutting line in a film laminate;
FIG. 11 is a schematic plan view showing a second cutting line in a film laminate;
FIG. 12 is a schematic cross-sectional view of a display device;
FIG. 13 is a schematic plan view of a display panel;
FIG. 14 is a schematic plan view showing sub-pixels according to an embodiment;
FIG. 15 is a schematic cross-sectional view taken along line I-I' of FIG. 14;
FIG. 16 is a block diagram of an electronic device according to an embodiment; and
FIG. 17 schematic views of various embodiments of an electronic device.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

The present disclosure relates to a film for a display device, a method of manufacturing the film for the display device, and an electronic device. Hereinafter, a film for a display device, a method of manufacturing the film for the display device, and an electronic device according to an embodiment will be described with reference to the accompanying drawings.

In the following drawings, a first direction DR1 and a second direction DR2 are defined as directions in which a plane where a film DF for a display device is arranged extends, and a third direction DR3 is defined as a direction perpendicular to the plane in which the film DF for the display device is arranged. Here, the third direction DR3 may be a thickness direction of the film. The directions DR1 and DR2 may be mutually orthogonal and together may span a plane corresponding to a plan view of the display device. Accordingly, features described as being visible "in a/the plan view" may be defined with reference to this plane spanned by DR1 and DR2. The plan view thus may correspond to a view onto a display side of the display device, i.e. as if an observer were looking directly at the display surface.

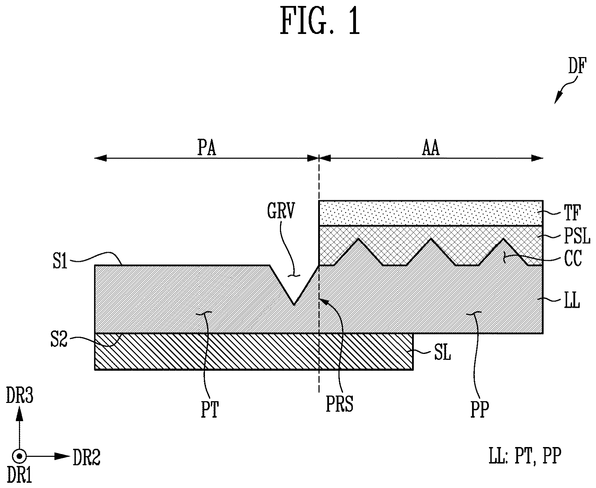

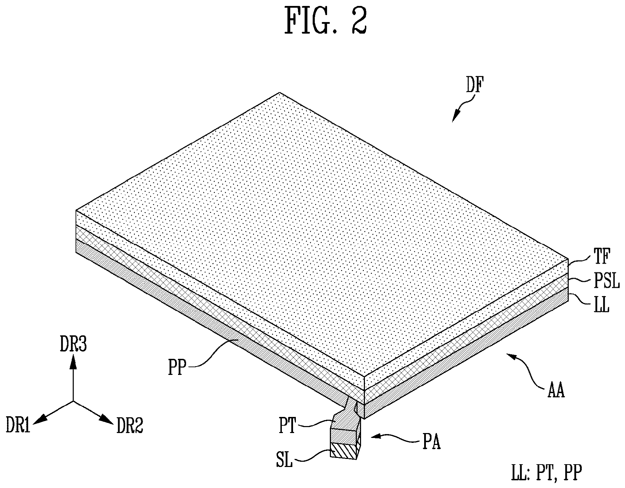

FIG. 1 is a schematic cross-sectional view of a film DF for the display device according to an embodiment. FIG. 2 is a schematic perspective view of the film DF for the display device according to an embodiment.

Referring to FIGS. 1 and 2, an embodiment of the film DF for the display device may include an attachment portion AA and a protrusion portion PA protruding from one side of the attachment portion AA.

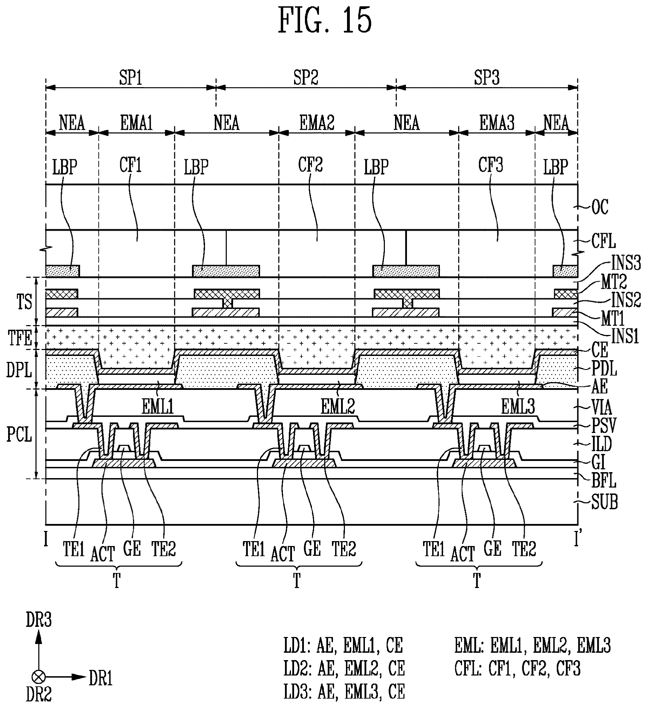

The attachment portion AA may be an area which is attached to an adherend (or an object to be attached) (e.g., a substrate SUB in FIG. 15). The shape (e.g., planar shape) of the attachment portion AA may be determined based on the outer shape of the adherend. In an embodiment, for example, the shape of the attachment portion AA may correspond to the outer shape of the adherend. In an embodiment, for example, the shape of the attachment portion AA may have a same as the outer shape of the adherend.

The area of the attachment portion AA may be different from that of the protrusion portion PA. In an embodiment, for example, the area of the attachment portion AA may be greater than that of the protrusion portion PA.

The protrusion portion PA may protrude from one side of the attachment portion AA and serve as a handle of the film DF for the display device.

The film DF for the display device may include a release layer LL, an adhesive layer PSL, a thin-film layer TF, and a support layer SL.

The release layer LL may be arranged under the film DF (e. g. on a lower side of the film) for the display device and serve to protect a lower portion of the film DF. The release layer LL may be a release film which is removed (or peeled off) during the process of attaching the film DF for the display device to the adherend.

The release layer LL may be arranged in a region overlapping the attachment portion AA and the protrusion portion PA when viewed in a plan view. The release layer LL may include a protection portion PP overlapping the attachment portion AA and a pull-tab portion PT overlapping the protrusion portion PA when viewed in a plan view (or when viewed in the third direction DR3).

The protection portion PP may serve to prevent damage to the appearance of a component (e.g., the adhesive layer PSL) arranged on the protection portion PP. The protection portion PP may have a shape corresponding to a configuration arranged on the protection portion PP. In an embodiment, for example, the protection portion PP may have a same shape as the configuration arranged on the protection portion PP. The pull-tab portion PT may protrude from one side PRS of the protection portion PP and serve as a handle when the release layer LL is peeled off from the film DF for the display device.

The release layer LL may include a first surface S1 (e.g., a front surface) and a second surface S2 (e.g., a rear surface). The first surface S1 may include irregularities (e.g., protrusions) CC in which a part of the first surface S1 protrudes, and a groove GRV in which a region of the first surface S1 is recessed. The first surface S1 may extend parallel to the plane spanned by DR1 and DR2 and may face in the DR3 direction. In other words, the first surface S1 is oriented in the same plane as the plan view and its normal vector points along DR3. The second surface S2 may likewise extend parallel to the plane spanned by DR1 and DR2, but may face in a direction opposite to DR3. Thus, first surface S1 and second surface S2 are disposed substantially parallel to each other, but oriented in opposite facing directions along DR3.

The irregularities CC may overlap the attachment portion AA when viewed in a plan view. The groove GRV may be formed by cutting or removing one region of the first surface S1 during the manufacturing process of the film DF for the display device, and may be adjacent to a boundary region (for example, the side PRS of the protection portion PP) between the protection portion PP and the pull-tab portion PT. In an embodiment, for example, the groove GRV may be arranged at the boundary region between the protection portion PP and the pull-tab portion PT.

The adhesive layer PSL may be arranged on the first surface S1 of the release layer LL. The adhesive layer PSL may be in contact (e. g. entirely or partially) with the first surface S1 of the release layer LL. The adhesive layer PSL may be arranged to overlap the attachment portion AA when viewed in a plan view. The adhesive layer PSL may serve to attach the thin-film layer TF to the adherend when the film DF for the display device is attached to the adherend.

A side surface of the adhesive layer PSL may coincide with a side surface of the protection portion PP when viewed in a plan view. In an embodiment, for example, the side surface of the adhesive layer PSL may overlap the side surface of the protection portion PP when viewed in a plan view. In an embodiment, for example, the side surface of the adhesive layer PSL may form a same plane (or a same planar surface) with the side surface of the protection portion PP when viewed in a plan view.

A lower surface of the adhesive layer PSL (e.g., a surface in contact with the first surface S1 of the release layer LL) may include unevenness. The unevenness included in the lower surface of the adhesive layer PSL may correspond to the shape of the irregularities CC formed on the first surface S1 of the release layer LL. The lower surface of the adhesive layer PSL may include the unevenness, and a passage through which air passes may be formed between the unevenness of the adhesive layer PSL. Thus, when the film DF for the display device is attached to the adherend, the risk of air being trapped in the adhesive layer PSL may be reduced.

The adhesive layer PSL may be a pressure sensitive adhesive (PSA), an optical clear adhesive (OCA), or an optical clear resin (OCR). However, the present disclosure is not necessarily limited thereto, and the adhesive layer PSL may include a photocurable adhesive material or a thermosetting adhesive material.

The thin-film layer TF may be arranged on the adhesive layer PSL. The thin-film layer TF may be in contact with the adhesive layer PSL. The thin-film layer TF may be arranged to overlap the attachment portion AA when viewed in a plan view. The thin-film layer TF may be attached to the adherend when the film DF for the display device is attached to the adherend.

When viewed in a plan view, a side surface of the thin-film layer TF may coincide with the side surface of the protection portion PP. In an embodiment, for example, when viewed in a plan view, the side surface of the thin-film layer TF may overlap the side surface of the protection portion PP. In an embodiment, for example, when viewed in a plan view, the side surface of the thin-film layer TF may form a same plane with the side surface of the protection portion PP.

When viewed in a plan view, respective end portions of the thin-film layer TF, the adhesive layer PSL, and the protection portion PP may coincide with each other. In an embodiment, for example, when viewed in a plan view, the end portions of the thin-film layer TF, the adhesive layer PSL, and the protection portion PP may overlap each other. Hereinafter, an end portion of a component may also be defined as a side surface of the component (or an edge of the component or a corner of the component). The respective end portions may be part of the attachment portion.

The thin-film layer TF may include a thin film. In an embodiment, for example, the thin-film layer TF may be a thin film having a thickness greater than zero (0) micrometer (µm) and less than or equal to about 50 µm.

According to an embodiment, the thin-film layer TF may include a metal. In an embodiment, for example, the thin-film layer TF may include copper (Cu). However, the present disclosure is not limited thereto.

According to an embodiment, the film DF for the display device may further include an upper release layer (not shown) arranged on the thin-film layer TF. The upper release layer may be arranged on an upper portion of the film DF for the display device and serve to protect the upper portion (e.g., the thin-film layer TF) of the film DF for the display device. The upper release layer may be a release film which is removed in the process of attaching the film DF for the display device to the adherend.

The upper release layer may have a higher adhesion than the release layer LL. The upper release layer may be removed after the release layer LL is first removed in the process of attaching the film DF for the display device to the adherend.

The support layer SL may be arranged on the second surface S2 of the release layer LL. The support layer SL may contact the second surface S2 (e. g. entirely or partially) of the release layer LL. In an embodiment, for example, the support layer SL may be arranged under the release layer LL (e. g. on a bottom of the film). The support layer SL may be arranged over the bottom of each of the pull-tab portion PT and the protection portion PP of the release layer LL. The support layer SL may overlap the pull-tab portion PT and the protection portion PP of the release layer LL when viewed in a plan view. The support layer SL may completely or entirely overlap the pull-tab portion PT when viewed in a plan view and partially overlap the protection portion PP when viewed in a plan view.

When viewed in a plan view, at least one region of the edge of the support layer SL may coincide with an edge of the pull-tab portion PT. In an embodiment, for example, when viewed in a plan view, at least one region of a side surface of the support layer SL may overlap a side surface of the pull-tab portion PT. In an embodiment, for example, when viewed in a plan view, at least one region of the side surface of the support layer SL may form a same plane (or a same planar surface) with the side surface of the pull-tab portion PT.

The support layer SL may support the pull-tap portion PT and serve to protect the release layer LL when the pull-tab portion PT is formed. In an embodiment, for example, the support layer SL may support the release layer LL when the groove GRV is formed, thereby reducing the risk that the release layer LL is completely cut.

The support layer SL may include, but is not necessarily limited to, at least one selected from polyethylene terephthalate (PET), thermoplastic polyurethane (TPU), polycarbonate (PC), polyvinylchloride (PVC), and polypropylene (PP).

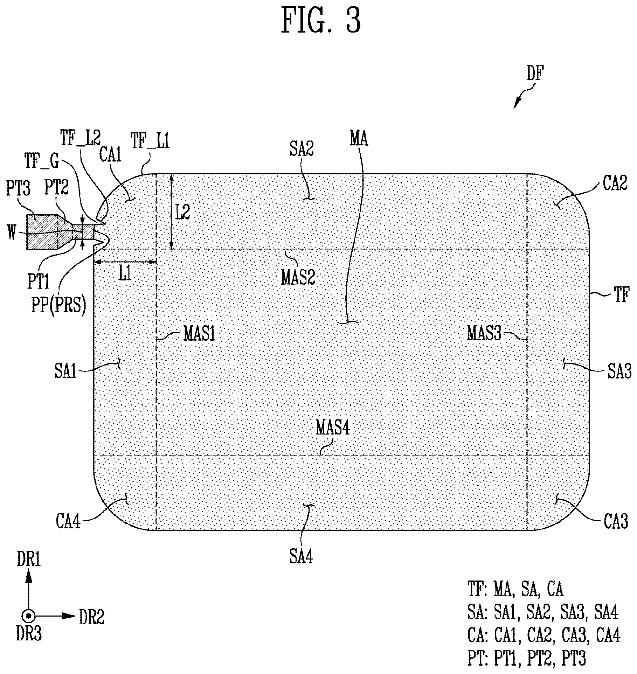

FIGS. 3 to 6 are schematic plan views of the film DF for the display device according to an embodiment.

Referring to FIG. 3, an embodiment of the thin-film layer TF may include a central area MA, side areas SA, and corner areas CA. The central area MA, the side areas SA, and the corner areas CA may overlap the attachment portion AA when viewed in a plan view.

The central area MA may correspond to a central portion of the thin-film layer TF, and may be arranged in the center of the thin-film layer TF. According to an embodiment, the central area MA may have a rectangular shape (e. g. when viewed in a plan view), and the central area MA may include a first edge MAS1 which is a left side of the central area MA, a second edge MAS2 which is an upper side of the central area MA, a third edge MAS3 which is a right side of the central area MA, and a fourth edge MAS4 which is a lower side of the central area MA. However, the present disclosure is not limited thereto, and according to embodiments, the central area MA may have various shapes.

The side areas SA may include a first side area SA1 extending from the first edge MAS1, a second side area SA2 extending from the second edge MAS2, a third side area SA3 extending from the third edge MAS3, and a fourth side area SA4 extending from the fourth edge MAS4.

The first side area SA1 may be connected to the first edge MAS1, the second side area SA2 may be connected to the second edge MAS2, the third side area SA3 may be connected to the third edge MAS3, and the fourth side area SA4 may be connected to the fourth edge MAS4.

The corner areas CA may be located at corners of the thin-film layer TF. The corner areas CA may each connect each of the side areas SA.

The corner areas CA may include a first corner area CA1 connecting (or connected between) the first side area SA1 and the second side area SA2, a second corner area CA2 connecting (or connected between) the second side area SA2 and the third side area SA3, a third corner area CA3 connecting (or connected between) the third side area SA3 and the fourth side area SA4, and a fourth corner area CA4 connecting (or connected between) the fourth side area SA4 and the first side area SA1.

According to an embodiment, the corner areas CA may have a rounded shape as shown in FIG. 3, but are not necessarily limited thereto. In an embodiment, for example, the corner areas CA may have an angled shape.

A length of a side where one of the corner areas CA and a corresponding one (e.g., an adjacent one) of the side areas SA meet each other may be greater than zero (0) millimeter (mm) and less than or equal to about 30 mm. In an embodiment, for example, a length of a side L1 where the first side area SA1 and the first corner area CA1 meet each other may be greater than zero (0) mm and less than or equal to about 30 mm. A length of a side L2 where the second side area SA2 and the first corner area CA1 meet each other may be greater than zero (0) mm and less than or equal to about 30 mm.

That is, according to an embodiment of the present disclosure, each of the corner areas CA may be defined as an area arranged at the corner of the thin-film layer TF while a straight line distance from the edge of the thin-film layer TF does not exceed about 30 mm.

One side PRS of the protection portion PP from which the pull-tap portion PT protrudes may coincide with the edge of one of the corner areas CA when viewed in a plan view. In an embodiment, for example, the one side PRS of the protection portion PP from which the pull-tab portion PT protrudes may overlap one of the corner areas CA (e.g., the edge of one of the corner areas CA) when viewed in a plan view.

As shown in FIG. 3, the one side PRS of the protection portion PP from which the pull-tap portion PT protrudes coincides with an edge of the first corner area CA1 when viewed in a plan view. However, the present disclosure is not limited thereto, and according to an embodiment, the one side PRS of the protection portion PP from which the pull-tab portion PT protrudes may coincide with an edge of one of the second corner area CA2, the third corner area CA3, and the fourth corner area CA4 in a plan view.

When the one side PRS from which the pull-tab portion PT protrudes is arranged so as to coincide with the edges of the side areas SA (for example, a region arranged to be greater than about 30 mm from the corner of the thin-film layer TF), the release layer LL of the film DF for the display device may not be properly peeled off. For example, when the release layer LL is peeled off from the film DF for the display device, there may be a risk that a reverse peeling phenomenon occurs in which the release layer LL is not peeled off and an upper release layer arranged over the thin-film layer TF is peeled off first.

On the other hand, according to the film DF for the display device according to an embodiment of the present disclosure, the one side PRS from which the pull-tab portion PT protrudes is arranged to coincide with an edge of one of the corner areas CA, such that the release layer LL of the film DF for the display device may be properly peeled off.

According to an embodiment, the pull-tab portion PT may include a first pull-tab portion PT1, a second pull-tab portion PT2, and a third pull-tab portion PT3. The first pull-tab portion PT1 may be connected to and extend from the protection portion PP. The second pull-tab portion PT2 may be connected to and extend from the first pull-tab portion PT1. The third pull-tab portion PT3 may be connected to and extend from the second pull-tab portion PT2.

According to an embodiment, the first pull-tab portion PT1 may have a rectangular shape. According to an embodiment, the first pull-tab portion PT1 may have a smaller width than the third pull-tab portion PT3, and may have a constant width W in a range of about 1 mm to about 40 mm. According to an embodiment, the second pull-tab portion PT2 may have a trapezoidal shape whose width increases as the distance from the first pull-tab portion PT1 increases (or as being away from the first pull-tab portion PT1). According to an embodiment, the third pull-tab portion PT3 may have a rectangular shape having a constant width.

However, the present disclosure is not limited thereto, and the shape and arrangement of the pull-tab portion PT may be variously changed as long as the one side PRS of the protection portion PP from which the pull-tap portion PT protrudes coincides with the edge of one of the corner areas CA in a plan view.

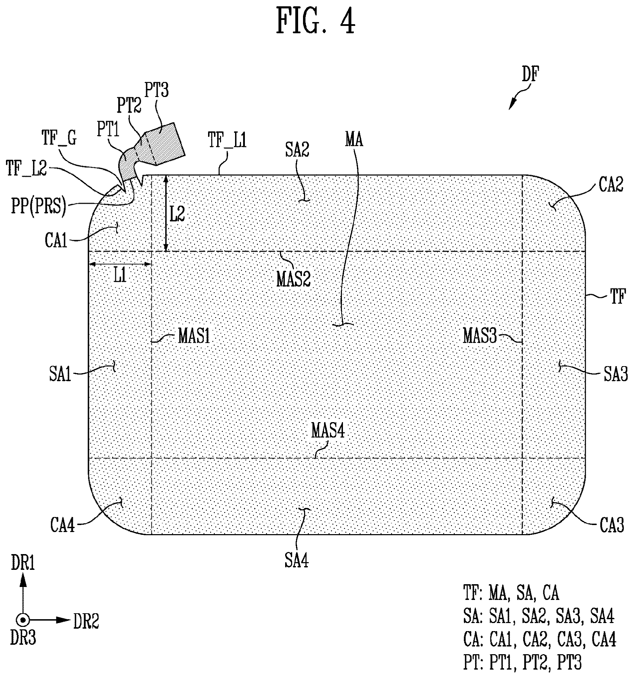

In an embodiment, for example, referring to FIG. 4, the first pull-tab portion PT1 of the pull-tab portion PT may be bent. In an embodiment, for example, the pull-tap portion PT of FIG. 4 may be arranged at a higher position relative to the pull-tab portion PT shown in FIG. 3.

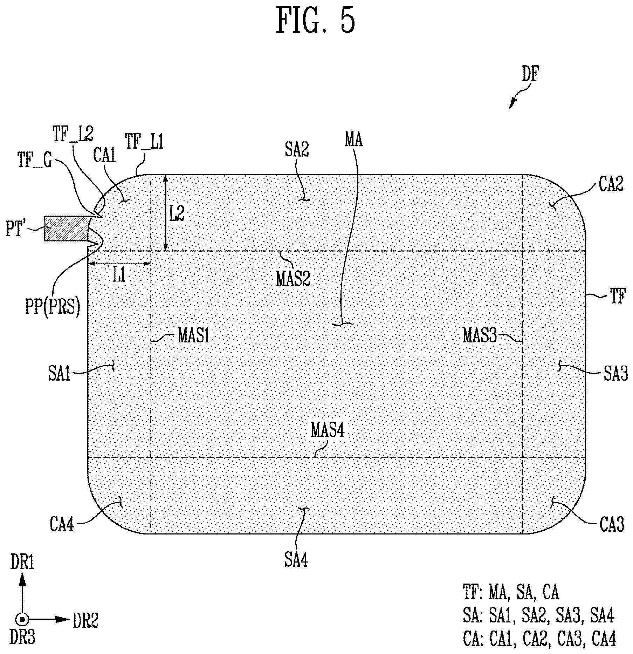

In embodiments of the disclosure, as described above, the shape and arrangement of the pull-tab portion PT may be variously changed. Referring to FIG. 5, a pull-tab portion PT' may have a rectangular shape. In an embodiment, for example, the pull-tab portion PT' may have a rectangular or square shape with a constant width. However, the present disclosure is not limited thereto, and according to an embodiment, the pull-tab portion PT' may have a trapezoidal shape.

However, the present disclosure is not limited thereto, and the shape of the pull-tap portion PT' and the arrangement of the pull-tab portion PT' may be variously changed as long as the one side PRS of the protection portion PP from which the pull-tap portion PT' protrudes coincides with the edge of one of the corner areas CA in a plan view.

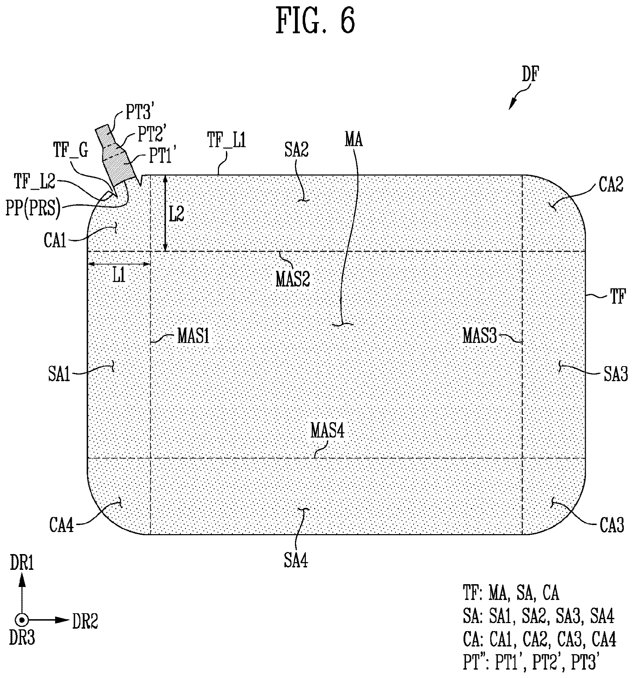

Referring to FIG. 6, according to an embodiment, a pull-tab portion PT" may include a first pull-tab portion PT1', a second pull-tab portion PT2', and a third pull-tab portion PT3'. The first pull-tab portion PT1' may have a rectangular shape. According to an embodiment, the first pull-tab portion PT1' may have a greater width than the third pull-tab portion PT3' and have a certain width. According to an embodiment, the second pull-tab portion PT2' may have a trapezoidal shape whose width decreases as the distance from the first pull-tab portion PT1' increases. According to an embodiment, the third pull-tab portion PT3' may have a width less than the width of the first pull-tab portion PT1', and may have a rectangular shape having a constant width.

However, the present disclosure is not limited thereto, and the shape and arrangement of the pull-tab portion PT" may be variously changed as long as the one side PRS of the protection portion PP from which the pull-tap portion PT" protrudes coincides with the edge of one of the corner areas CA in a plan view.

Referring to FIGS. 3 to 6, according to an embodiment, the thin-film layer TF may include a step forming portion TF_G having a shape in which at least a part of an edge thereof is indented toward the central area MA when viewed in a plan view. The step forming portion TF_G may be formed in plural according to an embodiment. At least one of the plurality of step forming portions TF_G may be arranged to overlap one of the corner areas CA when viewed in a plan view.

In an embodiment, as shown in FIGS. 3 to 6, the step forming portion TF_G may be a triangular groove in a plan view, but the present disclosure is not limited thereto. The step forming portion TF_G may have various shapes. In an embodiment, for example, the step forming portion TF_G may have a rectangular shape in a plan view. The step forming portion TF_G may be a portion in which the edge of the thin-film layer TF is not smoothly connected and forms a step.

In FIGS. 3 to 6, the step forming portion TF_G is shown as being immediately adjacent to the pull-tab portions PT, PT', and PT" in a plan view, but the present disclosure is not limited thereto. The step forming portion TF_G may be spaced apart from the pull-tab portion PT, PT', or PT" when viewed in a plan view. In an embodiment, for example, the step forming portion TF_G may be arranged at a distance in a range of about 20 mm to about 30 mm from the pull-tab portion PT, PT', or PT" in a plan view.

The edge of the thin-film layer TF may include first portions TF_L1 and second portions TF_L2. The second portions TF_L2 may be respectively arranged between the first portions TF_L1.

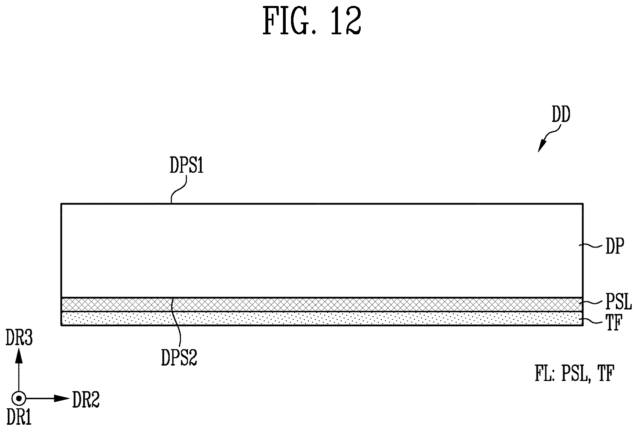

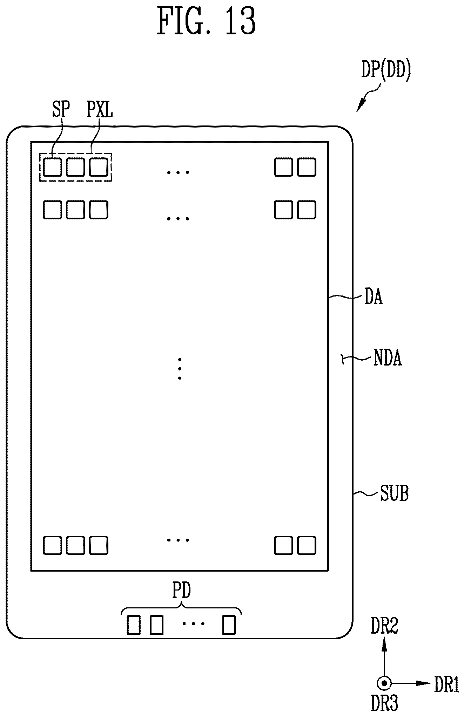

The first portions TF_L1 may be spaced apart from each other. The first portions TF_L1 may be edges of the thin-film layer TF which coincide with end portions of the display panel DP (see FIGS. 12 and 13) when a display device DD is manufactured. In an embodiment, for example, the first portions TF_L1 may overlap the end portions of the display panel DP when viewed in a plan view. In an embodiment, for example, the first portions TF_L1 may coincide with the end portions of the display panel DP when viewed in a plan view.

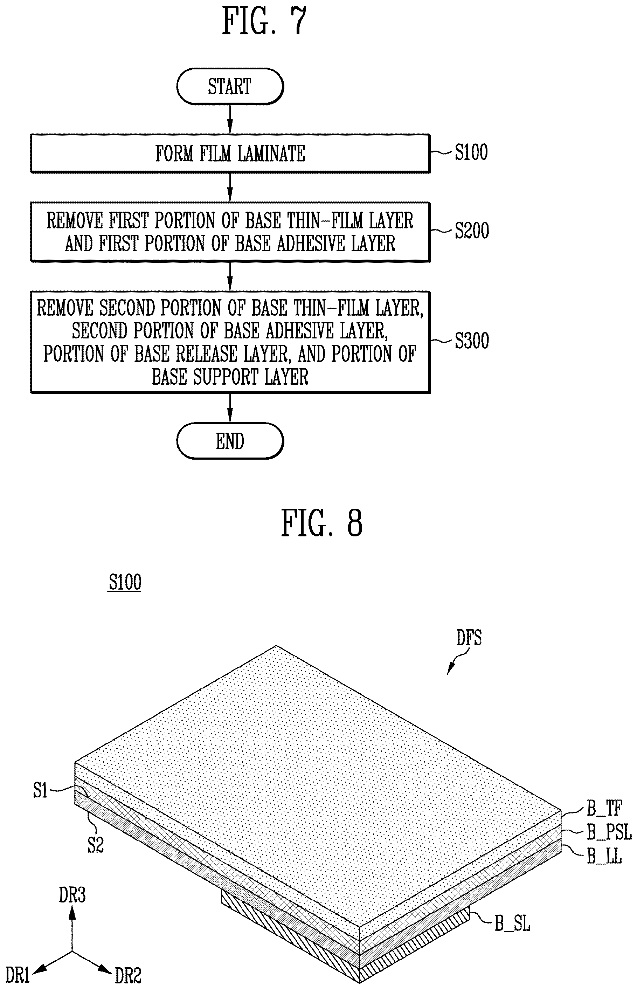

The second portions TF_L2 may define the step forming portion TF_G. In an embodiment, for example, the second portions TF_L2 may be the step forming portion TF_G which forms a step. In an embodiment, for example, the second portions TF_L2 may have a shape corresponding to the shape of the step forming portion TF_G in a plan view. The step forming portion TF_G may be formed in the process of manufacturing the film DF for the display device, which will be described below with reference to FIG. 7 and the subsequent drawings.

Hereinafter, an embodiment of a method of manufacturing the film DF for the display device will be described with reference to FIGS. 7 to 11. To avoid redundancy, any repetitive detailed descriptions of the same or like elements as those described above may be simplified or omitted.

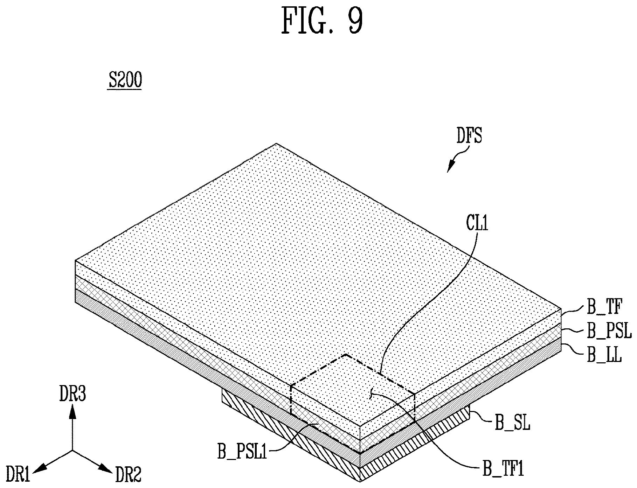

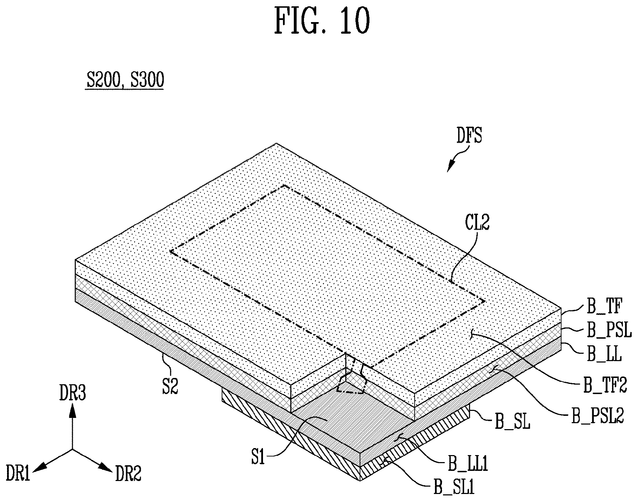

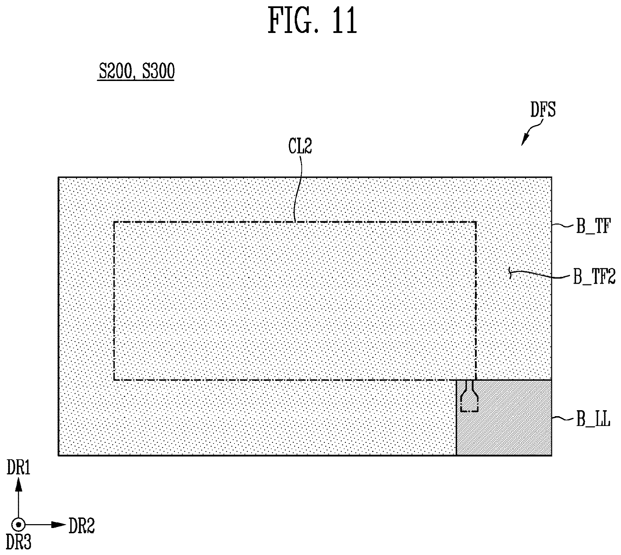

FIG. 7 is a flowchart illustrating a method of manufacturing the film DF for the display device according to an embodiment. FIG. 8 is a schematic perspective view showing a film laminate DFS. FIG. 9 is a schematic perspective view showing a first cutting line in the film laminate DFS. FIG. 10 is a schematic perspective view showing a second cutting line in the film laminate DFS. FIG. 11 is a schematic plan view showing the second cutting line in the film laminate DFS.

Referring to FIG. 7, an embodiment of a method of manufacturing the film DF for the display device may include forming a film laminate (S100), removing a first portion of a base thin-film layer and a first portion of a base adhesive layer (S200), and removing a second portion of the base thin-film layer, a second portion of a base adhesive layer, a portion of a base release layer, and a portion of a base support layer (S300).

Referring to FIG. 8, a film laminate DFS formed in the process of forming the film laminate (S100) may include a base release layer B_LL, a base adhesive layer B_PSL, a base thin-film layer B_TF, and a base support layer B_SL.

The base release layer B_LL, the base adhesive layer B_PSL, the base thin-film layer B_TF, and the base support layer B_SL may correspond to the release layer LL, the adhesive layer PSL, the thin-film layer TF, and the support layer SL of a film according to an embodiment, respectively, before being cut. In an embodiment, for example, the base release layer B_LL, the base adhesive layer B_PSL, the base thin-film layer B_TF, and the base support layer B_SL may be cut to form the release layer LL, the adhesive layer PSL, the thin-film layer TF, and the support layer SL, respectively.

The process S100 of forming the film laminate may include forming the base adhesive layer B_PSL on the first surface S1 of the base release layer B_LL, forming the base thin-film layer B_TF on the base adhesive layer B_PSL, and forming the base support layer B_SL on the second surface S2 of the base release layer B_LL.

The order in which the base release layer B_LL, the base adhesive layer B_PSL, the base thin-film layer B_TF, and the base support layer B_SL are stacked may be variously changed according to an embodiment.

The base support layer B_SL may be arranged to overlap the region in which the pull-tab portion PT is to be formed when viewed in a plan view. The base support layer B_SL may have a smaller area than the base release layer B_LL when viewed in a plan view. In an embodiment, for example, the base support layer B_SL may cover a portion of the second surface S2 of the base release layer B_LL and expose the remaining portion.

Referring to FIG. 9, the process S200 of removing the first portion of the base thin-film layer and the first portion of the base adhesive layer may include removing a first portion B_TF1 of the base thin-film layer B_TF and a first portion B_PSL1 of the base adhesive layer B_PSL along the first cutting line CL1. In the process S200, the first portion B_TF1 of the base thin-film layer B_TF and the first portion B_PSL1 of the base adhesive layer B_PSL may be cut along the first cutting line CL1 and separated from the base release layer B_LL. The first portion B_TF1 of the base thin-film layer B_TF and the first portion B_PSL1 of the base adhesive layer B_PSL may be cut in a same cutting process.

The first cutting line CL1 may be formed in a corner area of the base thin-film layer B_TF and the base adhesive layer B_PSL when viewed in a plan view. The first cutting line CL1 may overlap all of the base release layer B_LL, the base adhesive layer B_PSL, the base thin-film layer B_TF, and the base support layer B_SL when viewed in a plan view.

In FIG. 9, the first cutting line CL1 is shown as having a rectangular shape, but is not necessarily limited thereto.

Referring to FIGS. 9 and 10, the first portion B_TF1 of the base thin-film layer B_TF and the first portion B_PSL1 of the base adhesive layer B_PSL, which are removed in the process of removing the first portion of the base thin-film layer and the first portion of the base adhesive layer (S200), may have end portions which coincide with each other when viewed in a plan view. In an embodiment, for example, the first portion B_TF1 of the base thin-film layer B_TF and the first portion B_PSL1 of the base adhesive layer B_PSL may have end portions which overlap each other when viewed in a plan view. In an embodiment, for example, a side surface of the first portion B_TF1 of the base thin-film layer B_TF and a side surface of the first portion B_PSL1 of the base adhesive layer B_PSL may be on a same plane as each other.

Accordingly, the base thin-film layer B_TF and the base adhesive layer B_PSL remaining after the first portion B_TF1 of the base thin-film layer B_TF and the first portion B_PSL1 of the base adhesive layer B_PSL are removed may also have end portions which coincide with each other when viewed in a plan view. In an embodiment, for example, the base thin-film layer B_TF and the base adhesive layer B_PSL after the process S200 may have end portions which overlap each other when viewed in a plan view. In an embodiment, for example, side surfaces of the base thin-film layer B_TF and the base adhesive layer B_PSL after the process S200 may be on a same plane as each other.

In the process S200, the first portion B_TF1 of the base thin-film layer B_TF and the first portion B_PSL1 of the base adhesive layer B_PSL are removed, so that a part (in other words, a portion) of the first surface S1 of the base release layer B_LL may be exposed. In an embodiment, for example, the first portion B_TF1 of the base thin-film layer B_TF and a part of the first surface S1 of the base release layer B_LL overlapping the first portion B_PSL1 of the base adhesive layer B_PSL may be exposed. The remaining part other than the part of the first surface S1 may be covered by the base adhesive layer B_PSL and the base thin-film layer B_TF and may not be exposed.

As described above with reference to FIG. 1, in the process S200, when the first portion B_TF1 of the base thin-film layer B_TF and the first portion B_PSL1 of the base adhesive layer B_PSL are cut, at least a part of the first surface S1 of the base release layer B_LL is cut together, so that the groove GRV in which a part of the first surface S1 is recessed may be formed.

In the process S200, the base release layer B_LL may not be completely cut. In an embodiment, for example, in the process S200, the base release layer B_LL may not be cut completely through in a thickness direction (e.g., the third direction DR3). In this process S200, each of the first portion B_TF1 of the base thin-film layer B_TF and the first portion B_PSL1 of the base adhesive layer B_PSL may be cut completely through the base thin-film layer B_TF and the base adhesive layer B_PSL in the thickness direction.

The base support layer B_SL is arranged under the base release layer B_LL, so that in the process S200, the risk that the base release layer B_LL is torn when the groove GRV is formed may be reduced. If the base support layer B_SL is not arranged, there is a risk that the base release layer B_LL has a small thickness and is torn in a region overlapping the groove GRV when the groove GRV is formed. On the other hand, in the method of manufacturing the film DF for the display device according to an embodiment of the present disclosure, the base support layer B_SL supports the base release layer B_LL to increase the rigidity of the film laminate DFS and reduce the risk that the base release layer B_LL is torn.

Referring to FIGS. 10 and 11 together with FIGS. 1 to 6, the process S300 of removing a second portion of the base thin-film layer, a second portion of the base adhesive layer, a portion of the base release layer, and a portion of the base support layer may include removing a second portion B_TF2 of the base thin-film layer B_TF, a second portion B_PSL2 of the base adhesive layer B_PSL, a portion B_LL1 of the base release layer B_LL, and a portion B_SL1 of the base support layer B_SL along a second cutting line CL2. In the process S300, the second portion B_TF2 of the base thin-film layer B_TF, the second portion B_PSL2 of the base adhesive layer B_PSL, the portion B_LL1 of the base release layer B_LL, and the portion B_SL1 of the base support layer B_SL may be cut along the second cutting line CL2 to be separated from the film laminate DFS. The second portion B_TF2 of the base thin-film layer B_TF, the second portion B_PSL2 of the base adhesive layer B_PSL, the portion B_LL1 of the base release layer B_LL, and the portion B_SL1 of the base support layer B_SL may be cut in a same cutting process.

In the process S300, the second portion B_TF2 of the base thin-film layer B_TF may be cut, and the remaining base thin-film layer B_TF may form the thin-film layer TF. In the process S300, the second portion B_PSL2 of the base adhesive layer B_PSL may be cut, and the remaining base adhesive layer B_PSL may form the adhesive layer PSL. In the process S300, the base release layer B_LL remaining after the portion B_LL1 of the base release layer B_LL is cut may form the release layer LL including the protection portion PP and the pull-tab portion PT. In the process S300, the portion B_SL1 of the base support layer B_SL may be cut, and the remaining base support layer B_SL may form the support layer SL.

A portion of the second cutting line CL2 may correspond to the shape of each of the thin-film layer TF, the adhesive layer PSL, and the protection portion PP when viewed in a plan view. In an embodiment, for example, a portion of the second cutting line CL2 may coincide with an edge of each of the thin-film layer TF, the adhesive layer PSL, and the protection portion PP when viewed in a plan view. In an embodiment, for example, a portion of the second cutting line CL2 may overlap an edge of each of the thin-film layer TF, the adhesive layer PSL, and the protection portion PP when viewed in a plan view.

The remaining portion of the second cutting line CL2 may correspond to the shape of the pull-tab portion PT when viewed in a plan view. In an embodiment, for example, the remaining portion of the second cutting line CL2 may coincide with the edge of the pull-tab portion PT when viewed in a plan view. In an embodiment, for example, the remaining portion of the second cutting line CL2 may overlap the edge of the pull-tab portion PT when viewed in a plan view. In a plan view, when the remaining portion of the second cutting line CL2 corresponds to the shape of the pull-tab portion PT, so that the base release layer B_LL may include the pull-tap portion PT.

The second portion B_TF2 of the base thin-film layer B_TF, the second portion B_PSL2 of the base adhesive layer B_PSL, and the portion B_LL1 of the base release layer B_LL, which are removed in the process S300, may have end portions which coincide with each other when viewed in a plan view. In an embodiment, for example, the second portion B_TF2 of the base thin-film layer B_TF, the second portion B_PSL2 of the base adhesive layer B_PSL, and the portion B_LL1 of the base release layer B_LL may have end portions which overlap each other when viewed in a plan view. In an embodiment, for example, side surfaces of the second portion B_TF2 of the base thin-film layer B_TF, the second portion B_PSL2 of the base adhesive layer B_PSL, and the portion B_LL1 of the base release layer B_LL may form the same plane as each other.

Accordingly, the thin-film layer TF, the adhesive layer PSL, and the release layer LL (or the protection portion PP of the release layer LL) remaining after the second portion B_TF2 of the base thin-film layer B_TF, the second portion B_PSL2 of the base adhesive layer B_PSL, and the portion B_LL1 of the base release layer B_LL are removed may also have end portions which coincide with each other when viewed in a plan view. In an embodiment, for example, the thin-film layer TF, the adhesive layer PSL, and the release layer LL (or the protection portion PP of the release layer LL) after the process S300 may have end portions which overlap each other when viewed in a plan view. In an embodiment, for example, side surfaces of the thin-film layer TF, the adhesive layer PSL, and the release layer LL (or the protection portion PP of the release layer LL) after the process S300 may form the same plane as each other.

According to an embodiment, in the process S300, the pull-tab portion PT of the release layer LL may include the first pull-tab portion PT1, the second pull-tab portion PT2, and the third pull-tab portion PT3, as shown in FIGS. 3 and 4. According to an embodiment, where the first pull-tab portion PT1 has a width in a range of about 1 mm to about 40 mm, the groove GRV may have a smaller area when viewed in a plan view than a case where the first pull tap portion PT1 is formed to have a width exceeding 40 mm.

According to an embodiment, in the process S300, the pull-tab portion PT' of the release layer LL may have a rectangular shape in a plan view, as shown in FIG. 5. According to an embodiment, in the process S300, the pull-tab portion PT" of the release layer LL may include the first pull-tab portion PT1', the second pull-tab portion PT2', and the third pull-tab portion PT3', as shown in FIG. 6. However, the present disclosure is not limited thereto. In the process S300, the shape and the arrangement of the pull-tab portion PT and the area may vary as described above within the extent that the one side PRS of the protection portion PP coincides with the edge of one of the corner areas CA when viewed in a plan view.

The film DF for the display device according to the present disclosure is characterized in which the film laminate DFS is formed by primary cutting (S200) of removing the first portion of the base thin-film layer and the first portion of the base adhesive layer (hereinafter, this process may be defined as a process of primarily cutting the film laminate DFS), and by secondary cutting (S300) of removing the second portion of the base thin-film layer, the second portion of the base adhesive layer, the portion of the base release layer, and the portion of the base support layer (hereinafter, this process may be defined as a process of secondarily cutting the film laminate DFS). In the film DF for the display device, a step may be formed in a region cut twice (for example, a portion of an edge region of each of the adhesive layer PSL and the thin-film layer TF). In an embodiment, for example, the step forming portion TF_G may be formed on the thin-film layer TF, and a step forming portion corresponding to the step forming portion TF_G of the thin-film layer TF when viewed in a plan view may also be formed on the adhesive layer PSL.

The process of primarily cutting the film laminate DFS may be distinguished from the process of secondarily cutting the film laminate DFS. In an embodiment, for example, according to the process of primarily cutting the film laminate DFS, cut surfaces of the base thin-film layer B_TF and the base adhesive layer B_PSL may have end portions coinciding with each other, but the base release layer B_LL may not be completely cut. According to the process of secondarily cutting the film laminate DFS, each of the base thin-film layer B_TF, the base adhesive layer B_PSL, and the base release layer B_LL may be completely cut, so that the respective cut surfaces may have end portions coinciding with each other.

In the method of manufacturing the film DF for the display device according to an embodiment of the present disclosure, since the first cutting line CL1 is arranged in the corner area of the film laminate DFS, the area of the groove GRV may be reduced when the release layer LL is formed as compared with a case where the first cutting line CL1 is arranged along the edge of the film laminate DFS and has a closed-loop shape. When the first cutting line CL1 is arranged to have the closed-loop shape along the edge of the film laminate DFS, the groove GRV may have a closed-loop shape at a distance from the edge of the thin-film layer TF. On the other hand, when the first cutting line CL1 is arranged in the corner area of the film laminate DFS, the groove GRV may be formed in a boundary region between the protection portion PP and the pull-tab portion PT (for example, one side PRS of the protection portion PP).

At least a part of the adhesive layer PSL may be arranged in the groove GRV. In an embodiment, for example, in the process of primarily cutting the film laminate DFS, at least a portion of the adhesive layer PSL may flow into the groove GRV. In a plan view, the larger the area of the groove GRV is formed, the larger the amount of the adhesive layer PSL may flow into the groove GRV.

In a case where an excessive amount of the adhesive layer PSL flows into the groove GRV, when the release layer LL is removed from the film DF for the display device, the release layer LL may not be removed, and the upper release layer may be removed first. When the upper release layer is removed first, there is a risk that the thin-film layer TF is damaged and the reliability of the display device DD is deteriorated when the display device DD is manufactured. Therefore, a part of the release layer LL may be peeled off in advance manually in order to remove the release layer LL first, and thus, the process efficiency for manufacturing the display device DD may be reduced.

In the film DF for the display device according to an embodiment of the present disclosure, the groove GRV is formed in a boundary region between the protection portion PP and the pull-tab portion PT (for example, the one side PRS of the protection portion PP), so that the groove GRV may not have an excessive area in a plan view. Accordingly, an excessive amount of the adhesive layer PSL may not flow into the groove GRV, so that the release layer LL may be appropriately removed when the release layer LL is removed from the film DF for the display device. Accordingly, a part of the release layer LL may not be peeled off in advance, and the process efficiency may be increased.

In the method of manufacturing the film DF for the display device according to an embodiment of the present disclosure, the pull-tab portion PT is formed in the process of secondarily cutting the film laminate DFS, so that the pull-tab portion PT may not be separately attached to the lower portion of the release layer LL.

When the base thin-film layer B_TF, the base adhesive layer B_PSL, and the base release layer B_LL are completely cut at a time (or simultaneously by a same cutting process) without cutting the film laminate DFS in two stages, the base release layer B_LL may be completely cut, and thus, the groove GRV may not be formed. However, since the pull-tab portion PT is not formed, a separate configuration for serving as a handle of the film DF for the display device (hereinafter, a pull tab) may be desired to be formed. In an embodiment, for example, an adhesive layer may be formed under the release layer LL, and then a pull tab may be attached to the adhesive layer.

When the adhesive layer is formed for forming the pull tab, if the adhesive layer has an end protruding further than the release layer LL, the adhesive layer may be exposed to foreign matters. When the adhesive layer has a recessed end more inwardly than the release layer LL, the upper release layer may be peeled off first when the release layer LL is peeled off. Accordingly, the adhesive layer for forming the pull tab is preferably formed to have a same end portion as that of the release layer LL. However, since the adhesive layer for forming the pull tab does not undergo a separate cutting process, it may be difficult to form the adhesive layer to have a same end portion as that of the released layer LL.

In the film DF for the display device according to an embodiment of the present disclosure, the pull-tab portion PT is formed in the process of secondarily cutting the film laminate DFS. That is, the pull-tab portion PT may not be arranged under the release layer LL, but may be arranged in (or directly on) a same layer as the protection portion PP which is a part of the release layer LL. In the method of manufacturing the film DF for the display device according to an embodiment of the present disclosure, the process of forming a pull tab under the release layer LL may be omitted. Accordingly, the process efficiency may be increased, and the release layer LL may be appropriately peeled off, so that the reliability of the display device DD may be increased.

Hereinafter, the display device DD to which the film DF for the display device is attached will be described with reference to FIGS. 12 to 15. The display device DD according to an embodiment of the present disclosure is manufactured using the above-described film DF for the display device, and thus, may have high reliability. In addition, the manufacturing cost of the display device DD may also be reduced.

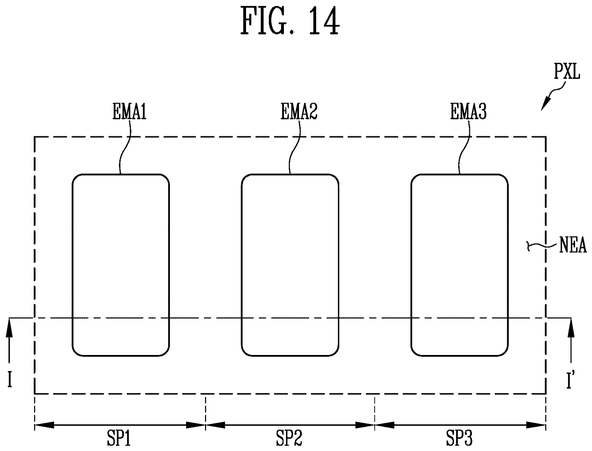

FIG. 12 is a schematic cross-sectional view of the display device DD. FIG. 13 is a schematic plan view of a display panel DP. FIG. 14 is a schematic plan view showing sub-pixels SP according to an embodiment. FIG. 15 is a schematic cross-sectional view taken along line I-I' of FIG. 14.

Referring to FIG. 12, an embodiment of the display device DD may include the display panel DP and a film FL. The film FL may correspond to a configuration according to an embodiment remaining after the release layer LL is peeled off from the adhesive layer PSL in the film DF for the display device. In an embodiment, for example, the film FL may correspond to a configuration remaining after the release layer LL is removed from the film DF for the display device in the process of attaching the film DF to the display device DD. The film FL may include the adhesive layer PSL and the thin-film layer TF.

In an embodiment, the display panel DP may include a first surface DPS1 corresponding to a front surface of the display panel DP on which an image or the like is displayed and a second surface DPS2 corresponding to a rear surface of the display panel DP. The film FL according to an embodiment may be arranged on (or attached to) the second surface DPS2. The film FL according to an embodiment may be arranged on the rear surface of the display panel DP. However, the present disclosure is not limited thereto. The film FL according to an embodiment may be for forming a component in the display device DD.

The adhesive layer PSL of the film FL may serve to attach the thin-film layer TF to the display panel DP. The thin-film layer TF may be arranged on the display panel DP through the adhesive layer PSL.

According to an embodiment, the thin-film layer TF may be arranged on the rear surface of the display panel DP to perform at least one of the following functions: supporting the display panel DP, protecting a lower portion of the display panel DP, and shielding ElectroMagnetic Interference (EMI).

Referring to FIG. 13, in an embodiment, the display panel DP (or the display device DD) may include a display area DA and a non-display area NDA. The display device DD displays an image through the display area DA. The non-display area NDA is arranged around the display area DA in a plan view.

In an embodiment, the display device DD may include a substrate SUB, the sub-pixels SP, and/or pads PD.

The sub-pixels SP are arranged in the display area DA on the substrate SUB. In an embodiment, the sub-pixels SP may be arranged in a matrix format in the first direction DR1 and the second direction DR2 intersecting the first direction DR1. However, embodiments are not limited thereto. In another embodiment, for example, the sub-pixels SP may be arranged in a zigzag pattern in the first direction DR1 and the second direction DR2. In another embodiment, for example, the sub-pixels SP may be arranged in a Pentile^{®} pattern. The first direction DR1 may be a row direction and the second direction DR2 may be a column direction. Two or more sub-pixels of the sub-pixels SP may constitute one pixel PXL.

A component for controlling the sub-pixels SP may be arranged in the non-display area NDA on the substrate SUB. In an embodiment, for example, wirings connected to the sub-pixels SP, such as gate lines and data lines, may be arranged in the non-display area NDA.

The pads PD are arranged in the non-display area NDA on the substrate SUB. The pads PD may be electrically connected to the sub-pixels SP through wirings. In an embodiment, for example, the pads PD may be connected to the sub-pixels SP via data lines.

Voltages and signals used for operating components included in the display device DD may be provided from a driver integrated circuit through the pads PD. In an embodiment, for example, the data lines may be connected to the driver integrated circuit via the pads PD. In an embodiment, for example, power supply voltages may be received from the driver integrated circuit via the pads PD.

In an embodiment, a circuit board may be electrically connected to the pads PD using a conductive adhesive member, such as an anisotropic conductive film. The circuit board may be a flexible circuit board or a flexible film having a flexible material. The driver integrated circuit may be mounted on a circuit board and electrically connected to the pads PD.

In an embodiment, the display area DA may have various shapes. The display area DA may have the shape of a closed loop including straight and/or curved sides in a plan view. In an embodiment, for example, the display area DA may have shapes such as a polygon, a circle, a semicircle, an ellipse, etc.

In an embodiment, the display device DD may have a flat display surface. In other embodiments, the display device DD may have an at least partially rounded display surface. In an embodiment, the display device DD may be bendable, foldable, or rollable. In this embodiment, the display device DD and/or the substrate SUB may include a flexible material.

Referring to FIG. 14, the pixel PXL may include first, second, and third sub-pixels SP1, SP2, and SP3 arranged in the first direction DR1. The first sub-pixel SP1 may include a first emission area EMA1 and a non-emission area NEA around the first emission area EMA1. The second sub-pixel SP2 may include a second emission area EMA2 and the non-emission area NEA around the second emission area EMA2. The third sub-pixel SP3 may include a third emission area EMA3 and the non-emission area NEA around the third emission area EMA3.

The first emission area EMA1 may be an area where light is emitted from a first light-emitting layer EML1 (see FIG. 15) of the first sub-pixel SP1. The second emission area EMA2 may be an area where light is emitted from a second light-emitting layer EML2 (see FIG. 15) of the second sub-pixel SP2. The third emission area EMA3 may be an area where light is emitted from a third light-emitting layer EML3 (see FIG. 15) of the third sub-pixel SP3.

Referring to FIG. 15, the first, second, and third sub-pixels SP1, SP2, and SP3 include the first, second, and third emission areas EMA1, EMA2, and EMA3, respectively, and the non-emission area NEA may be positioned between the first, second, and third emission areas EMA1, EMA2, and EMA3 of the first, second, and third sub-pixels SP1, SP2, and SP3.

Each of the first to third sub-pixels SP1 to SP3 may include a pixel circuit layer PCL, a display element layer DPL, and/or a thin film encapsulation layer TFE sequentially arranged on the substrate SUB.

The substrate SUB may form or provide a base surface. The substrate SUB may include a transparent insulating material to allow transmission of light. The substrate SUB may be a rigid substrate or a flexible substrate. The rigid substrate may be, for example, a glass substrate, a quartz substrate, a glass ceramic substrate, or a crystalline glass substrate. The flexible substrate may be a film substrate containing a polymeric organic material or a plastic substrate. In an embodiment, for example, the flexible substrate may include, but is not necessarily limited to, at least one selected from polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, or cellulose acetate propionate. In an embodiment, for example, the substrate SUB may include silicon.

The pixel circuit layer PCL may include a buffer layer BFL, a gate insulating layer GI, an interlayer insulating layer ILD, a passivation layer PSV, and/or a via layer VIA sequentially stacked on the substrate SUB in the third direction DR3.

The buffer layer BFL may be an inorganic insulating film including an inorganic material. The buffer layer BFL may include at least one of metal oxides such as silicon nitride (SiNx), silicon oxide (SiOx), silicon oxynitride (SiOxNy), and aluminum oxide (AlOx). The buffer layer BFL may be provided as a single layer, but may also be provided as multiple layers including at least two or more layers. In an embodiment where the buffer layer BFL has a multi-layer structure, the respective layers herein may include a same material as or different materials from each other. In another embodiment, the buffer layer BFL may be omitted depending on the material and process conditions of the substrate SUB.

A transistor T may be arranged on the buffer layer BFL. The transistor T may include an active pattern ACT, a gate electrode GE, a first transistor electrode TE1, and/or a second transistor electrode TE2.

The active pattern ACT may be arranged on the buffer layer BFL. The active pattern ACT may include a polysilicon semiconductor. In an embodiment, for example, the active pattern ACT may be formed through a low temperature polysilicon process. However, the present disclosure is not necessarily limited thereto, and the active pattern ACT may include an oxide semiconductor, a metal oxide semiconductor, or the like.

The active pattern ACT may include a channel region, a first contact region connected to one end of the channel region, and a second contact region connected to the other end of the channel region. The channel region, the first contact region, and the second contact region may include a semiconductor layer which may or may not be doped with impurities. In an embodiment, for example, the first contact region and the second contact region may include an impurity-doped semiconductor layer, and the channel region may include a semiconductor layer which is not doped with impurities. As the impurities, for example, p-type impurities may be used, but the present disclosure is not limited thereto. One of the first and second contact regions may be a source region and the other may be a drain region.

The gate insulating layer GI may be arranged on the active pattern ACT. The gate insulating layer GI may be an inorganic film (or an inorganic insulating film) including an inorganic material. In an embodiment, for example, the gate insulating layer GI may include at least one selected from metal oxides such as silicon nitride (SiNx), silicon oxide (SiOx), silicon oxynitride (SiOxNy), or aluminum oxide (AlOx). However, the material of the gate insulating layer GI is not limited to the above-described embodiments. According to an embodiment, the gate insulating layer GI may include an organic film (or an organic insulating film) including an organic material. The gate insulating layer GI may be provided as a single layer, but may also be provided as multiple layers of at least two or more layers.

The gate electrode GE may be arranged on the gate insulating layer GI. The gate electrode GE may overlap a channel region of the active pattern ACT in the third direction DR3. The gate electrode GE may have a single layer structure including at least one selected from copper (Cu), molybdenum (Mo), tungsten (W), aluminum neodymium (AINd), titanium (Ti), aluminum (Al), silver (Ag) and alloys thereof, or a double-layer or multilayer structure including a low-resistance material such as molybdenum (Mo), titanium (Ty), copper (Cu), aluminum (Al), or silver (Ag) to reduce wiring resistance.

The interlayer insulating layer ILD may be arranged on the gate electrode GE. The interlayer insulating layer ILD may include a same material as the gate insulating layer GI or one or more materials selected from the materials listed above as the constituent materials of the gate insulating layer GI.

The first transistor electrode TE1 and the second transistor electrode TE2 may be arranged on the interlayer insulating layer ILD. The first transistor electrode TE1 of the transistor T may be in contact with a first contact region of the active pattern ACT through a contact hole penetrating (or defined through) the interlayer insulating layer ILD and the gate insulating layer GI. In an embodiment where the first contact region is a source region, the first transistor electrode TE1 may be a first source electrode.

The second transistor electrode TE2 of the transistor T may be in contact with the second contact region on the other end of the active pattern ACT through a contact hole penetrating (or defined through) the interlayer insulating layer ILD and the gate insulating layer GI. In an embodiment where the second contact region is a drain region, the second transistor electrode TE2 may be a second drain electrode.

Each of the first transistor electrode TE1 and the second transistor electrode TE2 may include a same material as the gate electrode GE or may include one or more materials selected from the materials listed above as the constituent materials of the gate electrode GE.

The passivation layer PSV may be arranged over the first transistor electrode TE1 and the transistor electrodes TE2. The passivation layer PSV (e.g., a protective layer) may be an inorganic film (or an inorganic insulating film) containing an inorganic material or an organic film (or an organic insulating film) containing an organic material. The inorganic film may include, for example, at least one selected from a metal oxide such as silicon oxide (SiOx), silicon nitride (SiNx), silicon oxynitride (SiOxNy), or aluminum oxide (AlOx). The organic film may include, for example, at least one selected from an acrylic resin, an epoxy resin, a phenolic resin, a polyamide resin, a polyimide resin, an unsaturated polyester resin, a polyphenylene ether resin, a polyphenylene sulfide resin, and a benzocyclobutene resin.

According to an embodiment, the passivation layer PSV may include a same material as the interlayer insulating layer ILD, but the present disclosure is not limited thereto. The passivation layer PSV may be provided as a single layer, but may also be provided as multiple layers of at least two or more layers.

The via layer VIA may be arranged on the passivation layer PSV. The via layer VIA may include a same material as the passivation layer PSV or may include one or more materials selected from the materials listed above as the constituent materials of the passivation layers PSV. In an embodiment, the via layer VIA may be an organic film made of an organic material.

The display element layer DPL may be arranged on the pixel circuit layer PCL. The display element layer DPL may include a light-emitting element LD which emits light. The first to third sub-pixels SP1 to SP3 may respectively include first to third light-emitting elements LD1 to LD3.

The first light-emitting element LD1 may include an anode electrode AE, the first light-emitting layer EML1, and a cathode electrode CE. The second light-emitting element LD2 may include the anode electrode AE, the second light-emitting layer EML2, and the cathode electrode CE. A third light-emitting element LD3 may include the anode electrode AE, the third light-emitting layer EML3, and the cathode electrode CE. In an embodiment, for example, the first to third light-emitting elements LD1 to LD3 may be top-emitting organic light-emitting elements.

The anode electrodes AE of the respective sub-pixels SP may be arranged in the first, second, and third emission areas EMA1, EMA2, and EMA3 and may be spaced apart from each other. The anode electrode AE of each of the sub-pixels SP may be electrically connected to the first transistor electrode TE1 of the transistor T of each sub-pixel SP through a contact hole penetrating (or defined through) the via layer VIA and the passivation layer PSV.

The pixel defining layer (or a bank) PDL may be arranged on the anode electrode AE. The pixel defining layer PDL may define (or partition) the first, second, and third emission areas EMA1, EMA2, and EMA3 of the respective sub-pixels SP. The pixel defining layer PDL may define an opening which partially exposes the anode electrode AE of each sub-pixel SP.

The pixel defining layer PDL may be an organic insulating layer made of an organic material. The organic material may include an acryl resin, an epoxy resin, a phenolic resin, a polyamide resin, a polyimide resin, or the like. However, the present disclosure is not limited thereto, and the pixel defining layer PDL may be an inorganic insulating layer made of an inorganic material.

According to an embodiment, the pixel defining layer PDL may include a light absorbing material, or a light absorbing agent may be applied to absorb light introduced from the outside. In an embodiment, for example, the pixel defining layer PDL may include a carbon-based black pigment. However, the present disclosure is not necessarily limited thereto, and the pixel defining layer PDL may include an opaque metal material such as chromium (Cr), molybdenum (Mo), an alloy (MoTi) of molybdenum (Mo) and titanium (Ti), tungsten (W), vanadium (V), niobium (Nb), tantalum (Ta), manganese (Mn), cobalt (Co), or nickel (Ni) having a high light absorption rate.

A light-emitting layer EML of each sub-pixel SP may be arranged on the anode electrode AE exposed by the pixel defining layer PDL. The cathode electrode CE may be arranged on the light-emitting layer EML. The cathode electrode CE may be arranged throughout the first to third sub-pixels SP1 to SP3. In an embodiment, for example, the cathode electrode CE may be provided as a common electrode, but is not necessarily limited thereto.

The cathode electrode CE may include a metal layer such as silver (Ag), magnesium (Mg), aluminum (Al), platinum (Pt), palladium (Pd), gold (Au), nickel (Ni), neodymium (Nd), iridium (Ir), chromium (Cr), or alloys thereof, and/or a transparent conductive layer such as indium tin oxide (ITO), indium zinc oxide (IZO), zinc oxide (ZnO), or indium tin zinc oxide (ITZO). According to an embodiment, the cathode electrode CE may have a multilayer structure with at least a double layer including a thin metal layer, and may, for example, include a triple-layer structure of ITO/Ag/ITO.

The thin film encapsulation layer TFE may be arranged on the display element layer DPL. The thin film encapsulation layer TFE may have a single layer structure or a multilayer structure. The thin film encapsulation layer TFE may include an insulating layer covering the light-emitting element LD. The thin film encapsulation layer TFE may include at least one inorganic film and at least one organic film. In an embodiment, for example, the thin film encapsulation layer TFE may have a structure in which inorganic films and organic films are alternately stacked. In an embodiment, for example, the thin film encapsulation layer TFE may include a first inorganic film, an organic film arranged on the first inorganic film, and a second inorganic film arranged on the organic film.

A sensing layer TS may be arranged on the thin film encapsulation layer TFE. The sensing layer TS may include a first insulating layer INS1, a first conductive layer MT1, a second insulating layer INS2, a second conductive layer MT2, and/or a third insulating layer INS3.

The first insulating layer INS1 may be arranged on the thin film encapsulation layer TFE. The first insulating layer INS1 may be an inorganic insulating layer including an inorganic material. The inorganic insulating layer may include an inorganic insulating material such as silicon oxide (SiOx), silicon nitride (SiNx), silicon oxynitride (SiOxNy), aluminum oxide (AlxOy), titanium oxide (TiOx), tantalum oxide (TaxOy), hafnium oxide (HfOx), zinc oxide (ZnOx), or the like. According to an embodiment, the first insulating layer INS1 may be omitted or configured as the uppermost layer of the thin film encapsulation layer TFE.

The first conductive layer MT1 may be arranged on the first insulating layer INS1. The first conductive layer MT1 may be partially opened not to overlap the light-emitting element LD of each sub-pixel SP in the third direction DR3. In an embodiment, for example, the first conductive layer MT1 may be arranged to overlap the non-emission area NEA around the emission area (EMA1, EMA2, or EMA3).

The first conductive layer MT1 may include a metal layer or a transparent conductive layer. In an embodiment, for example, the metal layer may include molybdenum, titanium, copper, aluminum, and alloys thereof. The transparent conductive layer may include, but is not necessarily limited to, at least one selected from indium tin oxide (ITO), indium zinc oxide (IZO), zinc oxide (ZnO), indium tin zinc oxide (ITZO), PEDOT, and metal nanowires. The first conductive layer MT1 may form a connection electrode connecting the sensing electrodes.

The second insulating layer INS2 may be arranged on the first conductive layer MT1. The second insulating layer INS2 may include a same material as the first insulating layer INS1, or may include one or more materials selected from the materials listed above as the constituent materials of the first insulating layer INS1.

The second conductive layer MT2 may be arranged on the second insulating layer INS2. The second conductive layer MT2 may be partially opened not to overlap the light-emitting element LD of each sub-pixel SP in the third direction DR3. In an embodiment, for example, the second conductive layer MT2 may be arranged to overlap the non-emission area NEA around the emission area (EMA1, EMA2, or EMA3) in the third direction DR3.

The second conductive layer MT2 may include the same material as the first conductive layer MT1, or may include one or more materials selected from the materials listed above as the constituent materials of the first conductive layer MT1.

The second conductive layer MT2 may be electrically connected to the first conductive layer MT1 through a contact hole penetrating (or defined through) the second insulating layer INS2. The second conductive layer MT2 may form sensing electrodes.

The third insulating layer INS3 may be arranged on the second conductive layer MT2. The third insulating layer INS3 may be an organic insulating layer including an organic material. However, the present disclosure is not necessarily limited thereto, and according to an embodiment, the third insulating layer INS3 may include an inorganic film, or may have a structure in which an organic film and an inorganic film are alternately stacked.

A light shielding layer LBP may be arranged over the display element layer DPL, the thin film encapsulation layer TFE, and/or the sensing layer TS. The light shielding layer LBP may include an opening which overlaps the light-emitting element LD. In an embodiment, for example, the light shielding layer LBP may be arranged to overlap the non-emission area NEA around the emissions area (EMA1, EMA2, or EMA3).

The light shielding layer LBP may include a light shielding material to prevent light leakage and color mixing defects. In an example, the light shielding layer LBP may include, but is not necessarily limited to, a black matrix. According to an embodiment, the light shielding layer LBP may include carbon black (CB) and/or titanium black (TiBK).

A color filter layer CFL may be arranged on the light shielding layer LBP. The color filter layer CFL may include color filters CF1 to CF3 which match the color of each sub-pixel SP. By arranging the color filters CF1 to CF3 corresponding to the colors of the first to third sub-pixels SP1 to SP3, a full-color image may be displayed.

The color filter layer CFL may include a first color filter CF1 arranged in the first sub-pixel SP1 to selectively transmit light emitted from the first sub-pixel SP1, a second color filter CF2 arranged in the second sub-pixel SP2 to selectively transmit light emitted from the second sub-pixel SP2, and a third color filter CF3 arranged in the third sub-pixel SP3 to selectively transmit light emitted from the third sub-pixel SP3.

In an embodiment, the first color filter CF1, the second color filter CF2, and the third color filter CF3 may be, but are not necessarily limited to, a red color filter, a green color filter, and a blue color filter, respectively.

The first color filter CF1 may include a color filter material which selectively transmits light of a first color (or red). In an embodiment, for example, where the first sub-pixel SP1 is a red sub-pixel, the first color filter CF1 may include a red color filter material.

The second color filter CF2 may include a color filter material which selectively transmits light of a second color (or green). In an embodiment, for example, where the second sub-pixel SP2 is a green sub-pixel, the second color filter CF2 may include a green color filter material.

The third color filter CF3 may include a color filter material which selectively transmits light of a third color (or blue). In an embodiment, for example, where the third sub-pixel SP3 is a blue sub-pixel, the third color filter CF3 may include a blue color filter material.

An overcoat layer OC may be provided on the color filter layer CFL.

The overcoat layer OC may include a variety of materials suitable for protecting the underlying layers from foreign materials such as dust, moisture, etc. In an embodiment, for example, the overcoat layer OC may include at least one of an inorganic insulating film and an organic insulating film. In an embodiment, for example, the overcoat layer OC may include epoxy, but embodiments are not limited thereto.

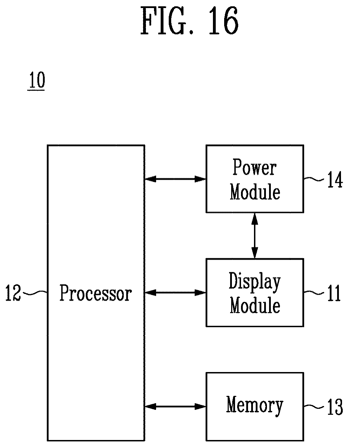

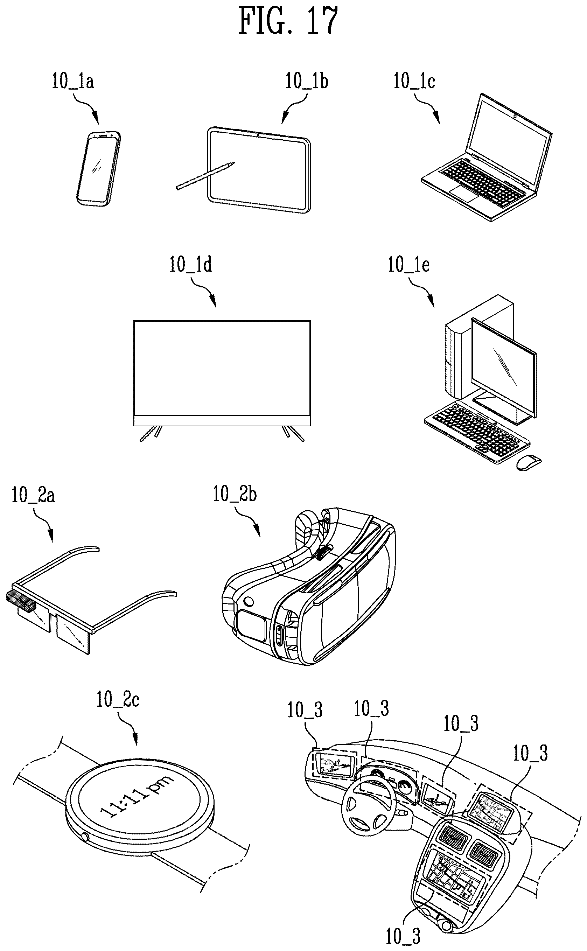

Hereinafter, an electronic device 10 including the display device DD will be described with reference to FIGS. 16 and 17.

The display device DD according to an embodiment may be applied to various electronic devices. The electronic device according to an embodiment may include the display device DD, and may further include modules or devices having additional functions other than the display device DD.

FIG. 16 is a block diagram of the electronic device 10 according to an embodiment. Referring to FIG. 16, the electronic device 10 according to an embodiment may include a display module 11, a processor 12, a memory 13, and a power module 14.

The processor 12 may include at least one selected from a central processing unit (CPU), an application processor (AP), a graphic processing unit (GPU), a communication processor (CP), an image signal processor (ISP), and a controller.

The memory 13 may store data and/or information used to operate the processor 12 or the display module 11. When the processor 12 executes an application stored in the memory 13, image data signals and/or input control signals may be transferred to the display module 11. The display module 11 may process the provided signals and output image information on a display screen.

The power module 14 may include a power supply module, such as a power adapter or a battery device, and a power conversion module. The power conversion module converts power supplied by the power supply module and generates power to operate the electronic device 10.

In an embodiment, at least one of the above-described components of the electronic device 10 may be included in the display device DD. In addition, in terms of functionality, some of the individual modules included in one module may be included in the display device DD and others may be provided separately from the display device DD. In an embodiment, for example, the display module 11 is included in the display device, whereas the processor 12, the memory 13, and the power module 14 are not included in the display device DD and are instead provided separately in the electronic device 10.

FIG. 17 shows schematic views of various embodiments of an electronic device.

Referring to FIG. 10, various types of electronic devices to which embodiments of the display device DD are applied may include an electronic device to display images such as a smartphone 10_1a, a tablet personal computer (PC) 10_1b, a laptop computer 10_1c, a television (TV) 10_1d, and a desktop monitor 10_1e, a wearable electronic device including a display module such as smart glasses 10_2a, a head-mounted display (HMD) 10_2b, and a smart watch 10_2c, and an automotive electronic device 10_3 including a display module such as a center information display (CID) disposed at the instrument cluster, the center fascia, and the dashboard of a vehicle, and a room mirror display.

According to embodiments of the present disclosure, a film for a display device and a method of manufacturing the film for the display device, from which a release layer may be properly peel off may be provided.

According to embodiments of the present disclosure, a film for a display device and a method of manufacturing the film for the display device that may improve process efficiency may be provided.

According to embodiments of the present disclosure, an electronic device including a display device with reduced manufacturing cost and improved reliability may be provided.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A film (DF) for a display device (DD), the film (DF) comprising:
a release layer (LL) including a protection portion (PP) and a pull-tab portion (PT) protruding from one side (PRS) of the protection portion (PP);
an adhesive layer (PSL) arranged on the release layer (LL); and
a thin-film layer (TF) arranged on the adhesive layer (PSL),
wherein end portions of the protection portion (PP), the adhesive layer (PSL), and the thin-film layer (TF) overlap each other in a plan view, and
wherein the protection portion (PP) and the pull-tab portion (PT) are arranged in a same layer as each other.

2. The film (DF) for the display device (DD) of claim 1, further comprising
a support layer (SL) arranged under the pull-tab portion (PT) and contacting the release layer (LL); and/or
wherein side surfaces of the protection portion (PP), the adhesive layer (PSL), and the thin-film layer (TF) are on a same plane.

3. The film for the display device of claim 1 or 2, wherein the thin-film layer (TF) comprises:
a central area (MA) arranged at a center of the thin-film layer (TF);
side areas (SA, SA1, SA2, SA3, SA4) extending from edges (MAS1, MAS2, MAS3, MAS4) of the central area (MA); and
corner areas (CA, CA1, CA2, CA3, CA4) connecting the side areas (SA, SA1, SA2, SA3, SA4) to each other,
wherein a length of a side (L1, L2) where one of the corner areas (CA, CA1, CA2, CA3, CA4) and a corresponding one of the side areas (SA, SA1, SA2, SA3, SA4) meet each other is greater than zero, 0, mm and less than or equal to about 30 mm, and
wherein the one side (L1, L2) of the protection portion (PP) from which the pull-tab portion (PT) protrudes overlaps a corresponding one of the corner areas (CA, CA1, CA2, CA3, CA4) in the plan view.

4. The film (DF) for the display device (DD) of any one of claims 1 to 3, wherein the release layer (LL) comprises a first surface (S1) on which the adhesive layer (PSL) is arranged,
wherein the first surface (S1) comprises:
irregularities (CC) in which a part of the first surface (S1) protrudes; and/or
a groove (GRV) defined by a recessed region of the first surface (S1), and wherein the groove (GRV) is adjacent to a boundary region between the protection portion (PP) and the pull-tab portion (PT).

5. The film (DF) for the display device (DD) of any one of claims 1 to 4, wherein the thin-film layer (TF) comprises copper, Cu, and/or
wherein the thin-film layer (TF) has a thickness greater than zero, 0, µm and less than or equal to about 50 µm.

6. A method of manufacturing a film (DF) for a display device (DD), the method comprising:
forming a base adhesive layer (B_PSL) on a first surface (S1) of a base release layer (B_LL);
forming a base thin-film layer (B_TF) on the base adhesive layer (B_PSL);
forming a base support layer (B_SL) on a second surface (S2) of the base release layer (B_LL);
removing (S200) a first portion (B_TF1) of the base thin-film layer (B_TF) and a first portion (B_PSL1) of the base adhesive layer (B_PSL); and
removing (S300) a second portion (B_TF2) of the base thin-film layer (B_TF), a second portion (B_PSL2) of the base adhesive layer (B_PSL), a portion (B_LL1) of the base release layer (B_LL), and a portion (B_SL1) of the base support layer (B_SL),
wherein in the removing (S200) the first portion (B_TF1) of the base thin-film layer (B_TF) and the first portion (B_PSL1) of the base adhesive layer (B_PSL), a portion of the first surface (S1) is exposed, and
wherein in the removing (S300) the second portion (B_TF2) of the base thin-film layer (B_TF), the second portion (B_PSL2) of the base adhesive layer (B_PSL), the portion (B_LL1) of the base release layer (B_LL), and the portion (B_SL1) of the base support layer (B_SL), a release layer (LL) including a protection portion (PP) and a pull-tab portion (PT) protruding from one side (PRS) of the protection portion (PP) is formed by removing the portion (B_LL1) of the base release layer (B_LL).

7. The method of claim 6, wherein in the removing (S200) the first portion (B_TF1) of the base thin-film layer (B_TF) and the first portion (B_PSL1) of the base adhesive layer (B_PSL),
a side surface of the first portion (B_TF1) of the base thin-film layer (B_TF) and a side surface of the first portion (B_PSL1) of the base adhesive layer (B_PSL) are cut to form a same planar surface; and
a remaining portion other than the portion of the first surface (S1) is covered by the base adhesive layer (B_PSL).

8. The method of claim 6 or 7, wherein in the removing (S300) the second portion (B_TF2) of the base thin-film layer (B_TF), the second portion (B_PSL2) of the base adhesive layer (B_PSL), the portion (B_LL1) of the base release layer (B_LL), and the portion (B_SL1) of the base support layer (B_SL),
the second portion (B_TF2) of the base thin-film layer (B_TF) is cut to form a thin-film layer (TF),
the second portion (B_PSL2) of the base adhesive layer (B_PSL) is cut to form an adhesive layer (PSL),
the portion (B_LL1) of the base release layer (B_LL) is cut to form the release layer (LL), and
the portion (B_SL1) of the base support layer (B_SL) is cut to form a support layer (SL),
wherein the second portion (B_TF2) of the base thin-film layer (B_TF), the second portion (B_PSL2) of the base adhesive layer (B_PSL), the portion (B_LL1) of the base release layer (B_LL), and the portion (B_SL1) of the support layer (SL) are cut in a same process, and
wherein end portions of the thin-film layer (TF), the adhesive layer (PSL), and the protection portion (PP) of the release layer (LL) overlap each other in a plan view.

9. The method of claim 8, wherein the thin-film layer (TF) comprises:
a central area (MA) arranged at a center of the thin-film layer (TF);
side areas (SA, SA1, SA2, SA3, SA4) extending from edges (MAS1, MAS2, MAS3, MAS4) of the central area (MA); and
corner areas (CA, CA1, CA2, CA3, CA4) connecting the side areas (SA, SA1, SA2, SA3, SA4) to each other,
wherein a length of a side (L1, L2) where one of the corner areas (CA, CA1, CA2, CA3, CA4) and a corresponding one of the side areas (SA, SA1, SA2, SA3, SA4) meet each other is greater than zero, 0, mm and less than or equal to about 30 mm, and
wherein the one side (PRS) of the protection portion (PP) from which the pull-tab portion (PT) protrudes overlaps a corresponding one of the corner areas (CA, CA1, CA2, CA3, CA4) in the plan view.

10. The method of any one of claims 6 to 9 or the film (DF) for the display device (DD) of any one of claims 1 to 5, wherein the pull-tab portion (PT) comprises:
a first pull-tab portion (PT1) connected to and extending from the protection portion (PP);
a second pull-tab portion (PT2) connected to and extending from the first pull-tab portion (PT1); and
a third pull-tab portion (PT3) connected to and extending from the second pull-tab portion (PT2),
wherein the second pull-tab portion (PT2) has a width increasing as a distance from the first pull-tab portion (PT1) increases in the plan view, or wherein the second pull-tab portion (PT2) has a width decreasing as a distance from the first pull-tab portion (PT1) increases in the plan view; and
wherein each of the first pull-tab portion (PT1) and the third pull-tab portion (PT3) has a constant width in the plan view.

11. The method of claim 10 or the film (DF) for the display device (DD) of claim 10, wherein the first pull-tab portion (PT1) has a smaller width or a greater width than the third pull-tab portion (PT3) in the plan view, and/or
wherein a width of the first pull-tab portion (PT1) is in a range of about 1 mm to about 40 mm in the plan view.

12. The method of any one of claims 6 to 9 or the film (DF) for the display device (DD) of any one of claims 1 to 5, wherein the pull-tab portion (PT) has a rectangular shape in the plan view.

13. The method of any one of claims 6 to 12, wherein in the removing (S200) the first portion (B_TF1) of the base thin-film layer (B_TF) and the first portion (B_PSL1) of the base adhesive layer (B_PSL),
a groove (GRV) is formed in a region of the first surface (S1) when the first portion (B_TF1) of the base thin-film layer (B_TF) and the first portion (B_PSL1) of the base adhesive layer (B_PSL) are cut.

14. An electronic device (10) comprising a display device (DD) and a processor (12),
wherein the display device (DD) comprises:
a display panel (DP); and
a film (DF) attached to a rear surface of the display panel (DP),
wherein the film (DF) comprises:
a thin-film layer (TF); and
an adhesive layer (PSL) attached between the thin-film layer (TF) and the display panel (DP), and
wherein an edge of the thin-film layer comprises:
first portions having end portions coinciding with the display panel (DP) in a plan view; and
second portions arranged between the first portions and connecting the first portions to each other, wherein the second portions defines a step in the plan view.

15. The electronic device (10) of claim 14, wherein the thin-film layer (TF) comprises:
a central area (MA) arranged in a center of the thin-film layer (TF);
side areas (SA, SA1, SA2, SA3, SA4) extending from edges (MAS1, MAS2, MAS3, MAS4) of the central area (MA); and
corner areas (CA, CA1, CA2, CA3, CA4) connecting the side areas (SA, SA1, SA2, SA3, SA4) to each other,
wherein a length of a side (L1, L2) where one of the corner areas (CA, CA1, CA2, CA3, CA4) and a corresponding one of the side areas (SA, SA1, SA2, SA3, SA4) meet each other is greater than zero, 0, mm and less than or equal to about 30 mm or less, and
wherein in the plan view, at least one of the second portions overlaps a corresponding one of the corner areas (CA, CA1, CA2, CA3, CA4).
